# EUROPEAN PATENT APPLICATION

(11) **EP 4 730 937 A1**
(43) Date of publication of application: **22.04.2026**
(21) Application number: 24902930.7
(22) Date of filing: 12.12.2024
(51) Int. Cl.: H05K 7/20

(54) **HEAT DISSIPATION PLATE, MIDDLE FRAME, AND ELECTRONIC DEVICE**

(30) Priority: 16.12.2023 CN 202311739785
(71) Applicant: Huawei Technologies Co., Ltd., Shenzhen, Guangdong 518129 (CN)
(72) Inventor: YANG, Ming, Shenzhen, Guangdong 518129 (CN); WANG, Tao, Shenzhen, Guangdong 518129 (CN); JIANG, Tiezhu, Shenzhen, Guangdong 518129 (CN); HUANG, Yu, Shenzhen, Guangdong 518129 (CN)
(74) Representative: MERH-IP Matias Erny Reichl Hoffmann Patentanwälte PartG mbB
(86) International application number: PCT/CN2024/138966
(87) International publication number: WO 2025/124513

(57) **Abstract**

This application provides a heat dissipation plate, a middle frame, and an electronic device. The heat dissipation plate includes a first cover, a second cover, a capillary structure, and a cooling medium. The second cover includes a middle region and an edge region disposed around the middle region, and the middle region includes a shaping region and an accommodation region connected to the shaping region. The edge region is fastened to the first cover, and the accommodation region of the middle region and the first cover are spaced from each other and enclose an accommodation cavity. The capillary structure is fastened to the first cover and located in the accommodation cavity, and the cooling medium is disposed in the accommodation cavity. The shaping region of the middle region is fastened to the first cover. In this way, when the accommodation region of the second cover is not flat, an acting force may be applied to the shaping region of the second cover, so that flatness of the accommodation region of the second cover can be adjusted to a specification, to greatly improve a yield in flatness of the heat dissipation plate, and further help resolve a problem that the heat dissipation plate pushes against a display and a problem of debonding of a battery.

## Description

This application claims priority to Chinese Patent Application No. 202311739785.X, filed with the China National Intellectual Property Administration on December 16, 2023 and entitled "HEAT DISSIPATION PLATE, MIDDLE FRAME, AND ELECTRONIC DEVICE", which is incorporated herein by reference in its entirety.

### TECHNICAL FIELD

This application relates to the field of electronic device technologies, and in particular, to a heat dissipation plate, a middle frame, and an electronic device.

### BACKGROUND

High-performance heat dissipation of a mobile phone is an important way to optimize performance of the mobile phone. A heat dissipation plate serves as a high-performance heat dissipation component to improve a heat dissipation capability of the entire phone. A conventional heat dissipation plate includes a first cover, a second cover, a capillary structure, and a coolant. An edge of the second cover is fastened to the first cover, so that the middle of the second cover and the first cover enclose a sealed cavity, and both the capillary structure and the coolant are disposed in the sealed cavity. However, in a procedure of assembling the heat dissipation plate, the first cover and/or the second cover are/is prone to deformation, leading to poor flatness of the first cover and/or the second cover.

### SUMMARY

An objective of embodiments of this application is to provide a heat dissipation plate, a middle frame, and an electronic device. The heat dissipation plate has high flatness.

According to a first aspect, this application provides a heat dissipation plate. The heat dissipation plate includes a first cover, a second cover, a capillary structure, and a cooling medium. The second cover includes a middle region and an edge region disposed around the middle region, and the middle region includes a shaping region and an accommodation region connected to the shaping region. The edge region is fastened to the first cover, and the accommodation region of the middle region and the first cover are spaced from each other and enclose an accommodation cavity. The capillary structure is fastened to the first cover and located in the accommodation cavity, and the cooling medium is disposed in the accommodation cavity. The shaping region of the middle region is fastened to the first cover.

It may be understood that, if the accommodation region of the second cover is convex away from the first cover, the accommodation region of the second cover has poor flatness. In an implementation of this application, a jig may be used to apply an acting force in a first direction to the shaping region of the second cover, so that the accommodation region of the second cover is no longer convex away from the first cover under a pulling force. In other words, the accommodation region of the second cover can be pulled flat, and the accommodation region of the second cover can be adjusted to good flatness. In other words, flatness of the accommodation region of the second cover can be adjusted to a specification. This greatly improves a yield in flatness of the heat dissipation plate. In addition, the shaping region of the second cover is fastened to the first cover, and no capillary structure is disposed between the shaping region and the first cover. In this case, the shaping region can bear a large acting force, to meet a requirement for flatness of the heat dissipation plate. In other words, when the acting force in the first direction is applied to the shaping region of the second cover, the second cover does not deform toward the first cover and squeeze the capillary structure, to avoid damage to the capillary structure.

It may be understood that, if the first cover is convex away from the second cover, the first cover also has poor flatness. In an implementation of this application, a jig may be used to apply an acting force in a second direction to the shaping region of the second cover, so that the first cover is no longer convex away from the second cover under a pulling force. In other words, the first cover can be pulled flat, and the first cover can be restored to good flatness. In other words, flatness of the first cover can be adjusted to a specification. This greatly improves a yield in flatness of the heat dissipation plate.

It may be understood that, the shaping region is disposed in the middle region of the second cover, so that the shaping region can be used to perform flatness shaping on the heat dissipation plate with a large area.

In some implementations, the shaping region is concave toward the first cover and fastened to the first cover. In this way, in comparison with a solution in which at least a part of the first cover is convex toward the shaping region and fastened to the shaping region, the first cover in this implementation has high flatness, which facilitates stable connection between the first cover and another mechanical part.

In some implementations, the accommodation region is disposed around the shaping region. In this way, the shaping region is far away from the edge region, and the shaping region can be responsible for flatness shaping of most regions of the accommodation region.

In some implementations, there are a plurality of shaping regions, and the plurality of shaping regions are spaced from each other in a length direction of the heat dissipation plate. In this way, two shaping regions can be responsible for flatness shaping of different positions in the accommodation region, to ensure that a large part of the accommodation region can be flattened once the large part deforms and protrudes.

In some implementations, the edge region of the second cover includes a first edge and a second edge that are arranged in the length direction of the heat dissipation plate, a shortest distance between the first edge and the second edge is a, there are two shaping regions, and a distance between a center of a 1^{st} shaping region and a center of a 2^{nd} shaping region is b, where a and b satisfy 0.25a≤b≤0.4a.

It may be understood that, when a and b satisfy 0.25a≤b≤0.4a, the 1^{st} shaping region and the 2^{nd} shaping region can cooperate with each other, to implement flatness shaping of most positions in the accommodation region.

In some implementations, the edge region of the second cover includes a third edge and a fourth edge that are arranged in a width direction of the heat dissipation plate, the third edge and the fourth edge are connected between the first edge and the second edge, a shortest distance between the third edge and the fourth edge is c, and a distance between the center of the 1^{st} shaping region and the third edge is d, where c and d satisfy 0.4c≤d≤0.6c.

It may be understood that, when c and d satisfy 0.4c≤d≤0.6c, the shaping regions can implement flatness shaping of most positions in the accommodation region.

In some implementations, a part of the accommodation region is concave toward the first cover and fastened to the capillary structure. It may be understood that, a structure of the accommodation region can resolve a problem that the accommodation region has low strength due to a small thickness.

According to a second aspect, this application provides a middle frame. The middle frame includes a side frame and a middle plate, the middle plate is fastened to an inner side surface of the side frame, and the middle plate includes a support plate and the foregoing heat dissipation plate. The support plate is provided with a hollow region, the first cover is fastened to the support plate, and the first cover covers the hollow region and encloses a battery compartment. It may be understood that good flatness of the heat dissipation plate helps improve flatness of the middle frame.

In some implementations, there are two shaping regions, a 1^{st} shaping region is directly opposite to a boundary between the battery compartment and the support plate, and a 2^{nd} shaping region is directly opposite to the battery compartment. In this way, the 1^{st} shaping region can perform flatness shaping on a partial region that is of the heat dissipation plate and that is directly opposite to the battery compartment, so that flatness of the partial region that is of the heat dissipation plate and that is directly opposite to the battery compartment can be adjusted to a specification, to greatly improve a yield in flatness of the partial region that is of the heat dissipation plate and that is directly opposite to the battery compartment. In this way, when the middle frame is used in an electronic device, both a battery and the heat dissipation plate are well bonded to a battery adhesive, and the battery is not prone to a problem of debonding. In addition, the 1^{st} shaping region can also perform flatness shaping on a partial region that is of the heat dissipation plate and that is directly opposite to the support plate, so that flatness of the partial region that is of the heat dissipation plate and that is directly opposite to the support plate can be adjusted to a specification, to greatly improve a yield in flatness of the partial region that is of the heat dissipation plate and that is directly opposite to the support plate. This can resolve a problem that the support plate squeezes the heat dissipation plate due to poor flatness and the heat dissipation plate deforms and squeezes a display. The display in implementations of this application has good reliability.

It may be understood that, the 2^{nd} shaping region can better perform flatness shaping on a region that is of the heat dissipation plate and that is directly opposite to the battery compartment, so that flatness of the heat dissipation plate can be adjusted to a specification, to greatly improve a yield in flatness of the heat dissipation plate. In this way, both the battery and the first cover of the heat dissipation plate are well bonded to the battery adhesive, and the battery is not prone to a problem of debonding.

In some implementations, the support plate includes a first connection region and a second connection region, the second connection region is fastened to the first connection region, the first cover includes a third connection region and a fourth connection region, and the fourth connection region is fastened to the third connection region. The third connection region of the heat dissipation plate is fastened to the first connection region of the support plate by using a fastener, and the fourth connection region of the heat dissipation plate is fastened to the second connection region of the support plate by using an adhesive and/or an adhesive layer.

It may be understood that, the heat dissipation plate may be fastened to the support plate through cooperation between the fastener, the adhesive, and the adhesive layer. In this case, connection between the heat dissipation plate and the support plate is more secure and stable.

In some implementations, the first connection region of the support plate is provided with a first groove, a fastening hole of the support plate is located in the first groove, at least a part of the third connection region of the first cover is concave toward a bottom wall of the first groove to form a second groove, a fastening hole of the first cover is located in the second groove, and a part of the fastener is located in the second groove. In this way, when the middle frame is used in the electronic device, the fastener and the display can avoid each other, to avoid a problem that the fastener pushes against the display. In addition, when the electronic device is impacted, the fastener does not impact the display, to prevent the display from impacting the fastener and producing a display defect such as a broken bright spot.

In some implementations, the third connection region includes a plurality of protrusions that are spaced from each other, the plurality of protrusions are disposed around the fastening hole of the first cover, and the plurality of protrusions abut against the first connection region. In this way, connection between the first cover and the support plate is closer and more secure.

In some implementations, the second connection region includes a first plate region, the adhesive includes a first adhesive, and the adhesive layer includes a first adhesive layer. The fourth connection region of the first cover is fastened to the first plate region of the support plate through cooperation between the first adhesive and the first adhesive layer.

It may be understood that, because the first adhesive has good adhesion and good impact resistance, connection between the first cover of the heat dissipation plate and the support plate is secure, so that a reliability test requirement can be better met.

In some implementations, the first adhesive is provided with a dispensing hole, and the first adhesive layer is disposed in the dispensing hole. It may be understood that, because the first adhesive layer has stronger adhesion, the first adhesive layer can fasten the heat dissipation plate to the support plate more securely. In this way, connection between the heat dissipation plate and the support plate is more secure, so that the reliability test requirement can be better met.

It may be understood that, the first adhesive may provide the dispensing hole (namely, dispensing space) for the first adhesive layer, to prevent glue from overflowing in a dispensing procedure. In addition, in a procedure of fastening the heat dissipation plate to the support plate, the first adhesive can well support the heat dissipation plate, to prevent the heat dissipation plate from crushing the glue in a press-fit procedure, and ensure stability of connection between the heat dissipation plate and the support plate.

In some implementations, the second connection region includes a first edge region, the first edge region is fastened to the first plate region, the adhesive layer includes a second adhesive layer, and the fourth connection region of the first cover is fastened to the first edge region of the support plate by using the second adhesive layer.

It may be understood that, because the second adhesive layer has stronger adhesion, the second adhesive can fasten the heat dissipation plate to the first edge region of the support plate more securely. In this way, connection between the heat dissipation plate and the support plate is more secure, so that the reliability test requirement can be better met.

In some implementations, a first barrier wall protrudes from the first edge region of the support plate, the first barrier wall is located between the second adhesive layer and the battery compartment, the middle frame further includes a barrier wall insulation member, and the barrier wall insulation member is connected between the fourth connection region of the first cover and the first barrier wall.

It may be understood that, the first barrier wall can prevent the glue from overflowing a dispensing groove and flowing into the battery compartment in a dispensing procedure. In addition, a thickness of the adhesive layer may be flexibly controlled by setting a height of the first barrier wall, to ensure that the second adhesive layer has a sufficient adhesive height, so that the heat dissipation plate can be stably connected to the support plate.

In this way, the fourth connection region of the first cover of the heat dissipation plate can be insulated from the first barrier wall of the support plate through the barrier wall insulation member.

In some implementations, the second connection region includes a first edge region, the first edge region is fastened to the first plate region, and in a width direction of the middle frame, a width D of the first edge region is greater than or equal to 1.5 millimeters. The adhesive includes a second adhesive, and the fourth connection region of the first cover is fastened to the first edge region of the support plate by using the second adhesive. In this case, the first cover may be fastened to the first edge region of the support plate by using the second adhesive. In this way, because the second adhesive has good adhesion and good impact resistance, connection between the first cover and the first edge region of the support plate is more secure, so that the reliability test requirement can be better met.

It may be understood that, in comparison with the solution in which the fourth connection region of the first cover is fastened to the first edge region of the support plate by using the second adhesive layer, in this implementation, the fourth connection region of the first cover is fastened to the first edge region of the support plate by using the second adhesive, and therefore a dispensing process may not be used in this implementation. This can avoid a risk of glue overflow, and can eliminate a need for the dispensing process, to reduce process costs. In addition, the first edge region of the support plate may not be provided with the first barrier wall. In this way, the first edge region of the support plate has a simple structure and is easy to produce. In addition, the first edge region of the support plate has high flatness, which facilitates connection between the first cover and the support plate.

In some implementations, the support plate includes a first connection region and a second connection region, the second connection region is fastened to the first connection region, the first cover includes a third connection region and a fourth connection region, the fourth connection region is fastened to the third connection region, and a thickness H of the first cover is less than or equal to 0.2 mm. The third connection region of the heat dissipation plate is fastened to the first connection region of the support plate by using a welding joint, and the fourth connection region of the heat dissipation plate is fastened to the second connection region of the support plate by using an adhesive and/or an adhesive layer. In this case, the welding joint is formed between the third connection region of the first cover and the first connection region of the support plate. The welding joint is a conductive member. In this case, the third connection region of the heat dissipation plate may be electrically connected to the first connection region of the support plate through the welding joint. Because the first connection region of the support plate is a grounding position for an antenna, the third connection region of the heat dissipation plate can be grounded through the welding joint.

It may be understood that, in comparison with a solution in which the heat dissipation plate is grounded through the fastener, in this implementation of this application, the heat dissipation plate is grounded through the welding joint, so that electrical connection between the heat dissipation plate and the support plate is more secure and reliable, and structures of the third connection region of the heat dissipation plate and the first connection region of the support plate are not prone to damage caused by providing an opening, to ensure that the heat dissipation plate and the support plate have good structure strength.

In some implementations, a part of the side frame forms a radiator of an antenna, or a radiator of an antenna is fastened to the inner side surface of the side frame. The support plate includes the first connection region and the second connection region, the second connection region is fastened to the first connection region, and the first connection region is a grounding position for the radiator of the antenna. The first cover includes the third connection region and the fourth connection region, and the fourth connection region is fastened to the third connection region. The third connection region of the heat dissipation plate is electrically connected to the first connection region of the support plate through a conductive member, and the fourth connection region of the heat dissipation plate is insulated from the second connection region of the support plate through an insulation member. In this case, a current of the antenna is not likely to be grounded at a non-grounding position of the heat dissipation plate, avoiding excitation of a new magnetic field at the non-grounding position of the heat dissipation plate, so that performance of the antenna is not affected.

In some implementations, the conductive member includes the fastener, the welding joint, or conductive foam, a material of the fastener includes a conductive material, the insulation member includes the adhesive or the adhesive layer, and materials of the adhesive and the adhesive layer include an insulating material.

It may be understood that, the material of the fastener includes the conductive material, and the first connection region of the support plate is the grounding position for the antenna, so that the third connection region of the heat dissipation plate can be electrically connected to the first connection region of the support plate through the fastener. In other words, the third connection region of the heat dissipation plate can be grounded through the fastener. In this way, the heat dissipation plate is not likely to generate clutter to the surrounding antenna, and therefore the performance of the antenna is not affected.

It may be understood that the fastener can securely fasten the third connection region of the heat dissipation plate to the first connection region of the support plate, and can also securely electrically connect the third connection region of the heat dissipation plate to the first connection region of the support plate. The fastener has effect of "one thing for a plurality of purposes".

It may be understood that, the materials of both the adhesive and the adhesive layer include the insulating material, so that the fourth connection region of the heat dissipation plate can be insulated from the second connection region of the support plate. In this case, the current of the antenna is not likely to be grounded at the non-grounding position of the heat dissipation plate, avoiding excitation of a new magnetic field at the non-grounding position of the heat dissipation plate, so that the performance of the antenna is not affected.

It may be understood that the adhesive and the adhesive layer can fasten the fourth connection region of the heat dissipation plate to the second connection region of the support plate, and can also electrically connect the fourth connection region of the heat dissipation plate to the second connection region of the support plate. The adhesive and the adhesive layer have effect of "one thing for a plurality of purposes".

In some implementations, a limiting boss protrudes from the inner side surface of the side frame, and a distance between the heat dissipation plate and the limiting boss is less than a distance between the heat dissipation plate and the inner side surface of the side frame. In this way, because a distance between the first cover of the heat dissipation plate and the limiting boss is smaller, positioning of the heat dissipation plate and the side frame can be implemented to some extent through cooperation between the first cover of the heat dissipation plate and the limiting boss. In this case, a plurality of fastening holes of the heat dissipation plate may also be accurately aligned with a plurality of fastening holes of the support plate. A process for locking the fastener into the fastening hole of the heat dissipation plate and the fastening hole of the support plate is simple. In addition, the fastener is not prone to a problem such as floating, loose locking, or assembly misalignment.

In some implementations, the support plate is provided with a plurality of first positioning holes, the first cover is provided with a plurality of second positioning holes, and the plurality of second positioning holes are provided opposite to the plurality of first positioning holes in a one-to-one correspondence. The first positioning holes are provided on the support plate, and the second positioning holes are provided on the heat dissipation plate. In this case, in a procedure of assembling the heat dissipation plate and the support plate, the first positioning holes are first aligned with the second positioning holes, and then positioning rods of an assembly tool are inserted into the first positioning holes and the second positioning holes, to fix a relative position of the heat dissipation plate on the support plate. In this case, the plurality of fastening holes of the heat dissipation plate may also be accurately aligned with the plurality of fastening holes of the middle plate. In this way, a process for locking the fastener into the fastening hole of the heat dissipation plate and the fastening hole of the support plate is simple. In addition, the fastener is not prone to a problem such as floating, loose locking, or assembly misalignment.

According to a third aspect, this application provides an electronic device. The electronic device includes a rear cover, a display, a battery, and the foregoing middle frame. At least a part of the display is fastened to the second cover of the heat dissipation plate, the battery is fastened to the first cover of the heat dissipation plate, and the battery is located in the battery compartment. The rear cover is fastened to the side frame of the middle frame, the rear cover is located on a side that is of the middle plate of the middle frame and that is away from the display, and the rear cover covers the battery.

It may be understood that, the battery is fastened to the first cover of the heat dissipation plate, and in this case, a support plate is no longer disposed between the battery and the first cover. In this way, in a thickness direction of the electronic device, a thickness of the support plate can be eliminated, which facilitates thinning of the electronic device. In addition, the heat dissipation plate can dissipate heat from the battery and a flexible display, and can also support the battery and the flexible display. The heat dissipation plate has effect of "one thing for a plurality of purposes".

It may be understood that, because flatness of the heat dissipation plate can be adjusted to a specification, a yield in flatness of the heat dissipation plate can be greatly improved. This can resolve a problem that the heat dissipation plate squeezes the display. In other words, the display in implementations of this application has good reliability. In addition, both the battery and the first cover of the heat dissipation plate are well bonded to a battery adhesive, and the battery is not prone to a problem of debonding.

In some implementations, the electronic device further includes a display insulation member, and the display insulation member is located between the display and the second cover. In this implementation, the display insulation member is disposed between a part of the middle of the display and the second cover, to separate the middle of the display from the second cover, so as to avoid electrical connection between the display and the second cover.

In some implementations, the electronic device further includes a circuit board, and the circuit board is fastened to the support plate and located on a side that is of the support plate and that is away from the first cover. In this implementation, heat generated by the circuit board may be transmitted to the first cover through the support plate. In this way, the first cover can also dissipate the heat generated by the circuit board.

### BRIEF DESCRIPTION OF DRAWINGS

To describe technical solutions in embodiments of this application or in the background more clearly, the following briefly describes accompanying drawings for describing embodiments of this application or the background.
FIG. 1 is a diagram of a structure of an electronic device according to an embodiment of this application;
FIG. 2 is a partial exploded view of the electronic device shown in FIG. 1 in some embodiments;
FIG. 3 is a partial cross-sectional view of the electronic device shown in FIG. 1 and cut along A-A in some embodiments;
FIG. 4 is a diagram of a partial structure of the electronic device shown in FIG. 1 in an implementation;
FIG. 5 is an enlarged view of a middle frame shown in FIG. 2 at another angle;
FIG. 6 is a partial exploded view of a middle frame shown in FIG. 2 in an implementation;
FIG. 7 is a partial exploded view of a heat dissipation plate shown in FIG. 6 in an implementation;
FIG. 8 is a partial cross-sectional view of a heat dissipation plate shown in FIG. 6 and cut along B-B in some embodiments;
FIG. 9 is a partial cross-sectional view of a middle frame shown in FIG. 2 and cut along C-C in some embodiments;
FIG. 10 is a partial cross-sectional view of a heat dissipation plate shown in FIG. 6 and cut along B-B in some other embodiments;
FIG. 11 is a partial exploded view of a middle frame shown in FIG. 2 in another implementation;
FIG. 12 is an enlarged view of a part of the middle frame shown inFIG. 11 in an implementation;
FIG. 13 is a partial cross-sectional view of a middle frame shown in FIG. 2 and cut along D-D in some embodiments;
FIG. 14 is a diagram of a partial structure of a middle frame shown in FIG. 2 in an implementation;
FIG. 15 is a partial cross-sectional view of a middle frame shown in FIG. 2 and cut along E-E in some embodiments;
FIG. 16 is a partial cross-sectional view of a middle frame shown in FIG. 2 and cut along F-F in some embodiments;
FIG. 17 is a partial cross-sectional view of a middle frame shown in FIG. 2 and cut along F-F in some other embodiments;
FIG. 18 is a partial cross-sectional view of a middle frame shown in FIG. 2 and cut along D-D in some other embodiments;
FIG. 19 is a partial cross-sectional view of a middle frame shown in FIG. 2 and cut along D-D in still some embodiments;
FIG. 20 is a partial cross-sectional view of a middle frame shown in FIG. 2 and cut along F-F in some other embodiments;
FIG. 21 is a partial cross-sectional view of a middle frame shown in FIG. 2 and cut along G-G in some embodiments; and
FIG. 22 is a diagram of a structure of a middle frame shown in FIG. 2 at another angle in an implementation.

### DESCRIPTION OF EMBODIMENTS

The following describes embodiments of this application with reference to accompanying drawings in embodiments of this application.

In the descriptions of embodiments of this application, it should be noted that the terms "installation" and "connection" should be understood in a broad sense unless there is a clear stipulation and limitation. For example, "connection" may be detachable connection, nondetachable connection, direct connection, or indirect connection through an intermediate medium. "Fastened" means that two parts are connected to each other and a relative position relationship remains unchanged after the two parts are connected. Orientation terms mentioned in embodiments of this application, for example, "top", "bottom", "up", "down", "inside", and "outside", are merely directions with reference to the accompanying drawings. Therefore, the orientation terms are used to better and more clearly describe and understand embodiments of this application, instead of indicating or implying that a specified apparatus or element needs to have a specific orientation, and be constructed and operated in the specific orientation. Therefore, this cannot be understood as a limitation on embodiments of this application. "A plurality of" means at least two. "A and/or B" includes three solutions, which are specifically a solution A, a solution B, and a solution AB. "Electrical connection" means that an electrical signal may be conducted between each other. In addition, obtaining an integrated structure of two parts by using an integral forming process means that, in a procedure of forming one of the two parts, the part is connected to the other part, and the two parts are connected without secondary processing (for example, bonding, welding, snap-fitting, or screwing).

In embodiments of this application, the terms "first", "second", "third", and "fourth" are merely intended for a purpose of description, and shall not be understood as an indication or implication of relative importance or an implicit indication of a quantity of indicated technical features. Therefore, a feature defined by "first", "second", "third", or "fourth" may explicitly or implicitly include one or more features.

In addition, in embodiments of this application, a mathematical concept such as parallel or perpendicular is mentioned. These limitations are all for the current process level, but not for an absolute strict definition in the mathematical sense. A small deviation is allowed, which can be approximately parallel or perpendicular. For example, that A is parallel to B means that A is parallel or approximately parallel to B, and an included angle of 0 degrees to 10 degrees between A and B is allowed. For example, that A is perpendicular to B means that A is perpendicular or approximately perpendicular to B, and an included angle of 80 degrees to 100 degrees between A and B is allowed.

It may be understood that the specific embodiments described herein are merely used to explain a related invention, but not a limitation on the invention. In addition, it should be noted that, for ease of description, only a part related to the invention is shown in the accompanying drawings.

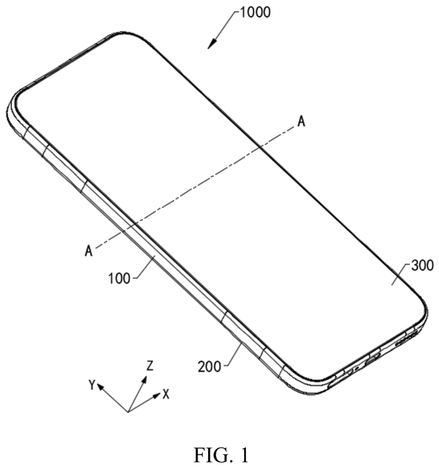

FIG. 1 is a diagram of a structure of an electronic device 1000 according to an embodiment of this application.

As shown in FIG. 1, in some embodiments, the electronic device 1000 may be a device having a middle frame 100, such as a mobile phone, a tablet personal computer (tablet personal computer), a laptop computer (laptop computer), a personal digital assistant (personal digital assistant, PDA), a camera, a personal computer, a notebook computer, a vehicle-mounted device, a wearable device, augmented reality (augmented reality, AR) glasses, an AR helmet, virtual reality (virtual reality, VR) glasses, or a VR helmet. The electronic device 1000 in the embodiment shown in FIG. 1 is described by using the mobile phone as an example.

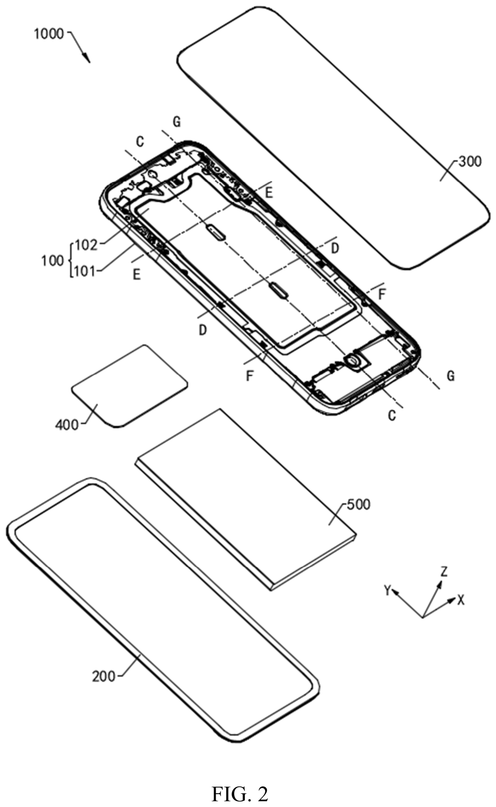

FIG. 2 is a partial exploded view of the electronic device 1000 shown in FIG. 1 in some embodiments.

As shown in FIG. 1 and FIG. 2, the electronic device 1000 includes a middle frame 100, a rear cover 200, a display 300, a circuit board 400, and a battery 500. It may be understood that FIG. 1 and the following related accompanying drawings merely schematically show some parts included in the electronic device 1000. Actual shapes, actual sizes, actual positions, and actual structures of these parts are not limited by FIG. 1 and the following accompanying drawings. In addition, for ease of description, the following is defined: The electronic device 1000 has a first direction X, a second direction Y, and a third direction Z, the first direction X may be a width direction of the electronic device 1000, the second direction Y may be a length direction of the electronic device 1000, and the third direction Z may be a thickness direction of the electronic device 1000. In some implementations, a coordinate system of the electronic device 1000 may be flexibly set according to a specific actual requirement.

In some embodiments, the display 300 may be an organic light-emitting diode (organic light-emitting diode, OLED) display, an active-matrix organic light-emitting diode (active-matrix organic light-emitting diode, AMOLED) display, a liquid crystal display (liquid crystal display, LCD), or the like.

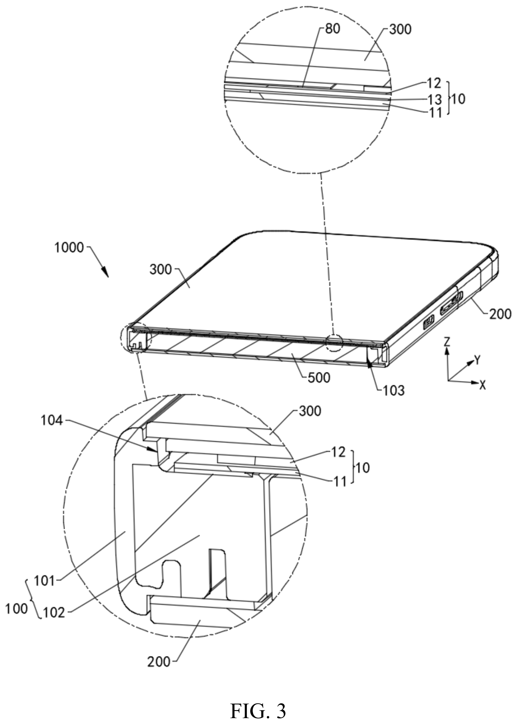

FIG. 3 is a partial cross-sectional view of the electronic device 1000 shown in FIG. 1 and cut along A-A in some embodiments.

As shown in FIG. 2 and FIG. 3, the middle frame 100 includes a side frame 101 and a middle plate 102. The middle plate 102 is fastened to an inner side surface 104 of the side frame 101. The side frame 101 may be disposed around the middle plate 102.

As shown in FIG. 2 and FIG. 3, the display 300 is fastened to the middle frame 100. It may be understood that the middle frame 100 may be configured to support the display 300.

In some embodiments, an edge of the display 300 may be fastened to the side frame 101 of the middle frame 100. At least a part of the middle of the display 300 may be fastened to the middle plate 102 of the middle frame 100. In some implementations, a manner of connecting the display 300 to the middle frame 100 is not specifically limited.

As shown in FIG. 2 and FIG. 3, the rear cover 200 is fastened to the middle frame 100. The rear cover 200 is located on a side that is of the middle plate 102 of the middle frame 100 and that is away from the display 300. The rear cover 200 may be configured to cover the middle plate 102 of the middle frame 100 and a related component on the middle plate 102.

In some embodiments, an edge of the rear cover 200 may be fastened to the side frame 101 of the middle frame 100. The middle of the rear cover 200 may be disposed opposite to the middle plate 102 of the middle frame 100.

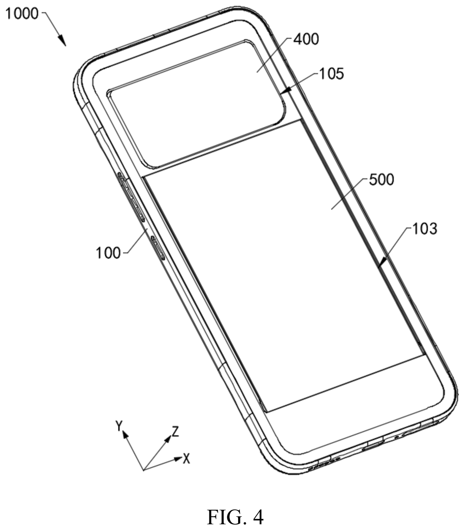

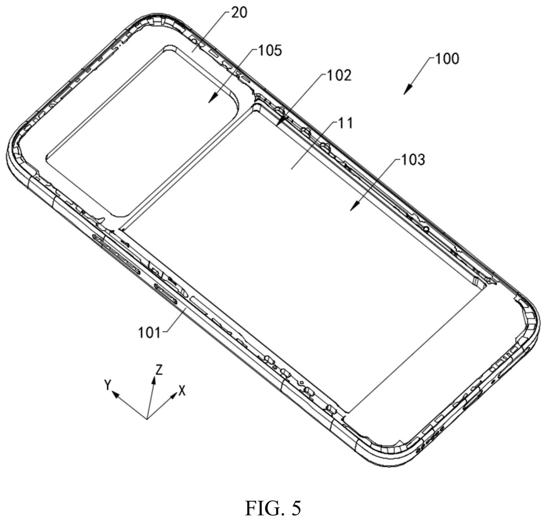

FIG. 4 is a diagram of a partial structure of the electronic device 1000 shown in FIG. 1 in an implementation. FIG. 4 may be a diagram, in which the rear cover 200 is not shown, of the back of the electronic device 1000 shown in FIG. 1. FIG. 5 is an enlarged view of the middle frame 100 shown in FIG. 2 at another angle.

As shown in FIG. 3 to FIG. 5, the middle plate 102 of the middle frame 100 may be provided with a battery compartment 103 and an accommodation groove 105. The battery compartment 103 and the accommodation groove 105 may communicate with each other, or may be separated from each other. Openings of the battery compartment 103 and the accommodation groove 105 on the middle plate 102 may face the rear cover 200.

In some embodiments, the battery 500 is fastened to the middle plate 102 of the middle frame 100, and the battery 500 is located in the battery compartment 103. The circuit board 400 is fastened to the middle plate 102 of the middle frame 100, and the circuit board 400 is located in the accommodation groove 105. The rear cover 200 covers the battery 500 and the circuit board 400, to protect the battery 500 and the circuit board 400. It may be understood that depths of the battery compartment 103 and the accommodation groove 105 in the Z-axis direction may be flexibly set according to different requirements, to better match sizes of the battery 500 and the circuit board 400.

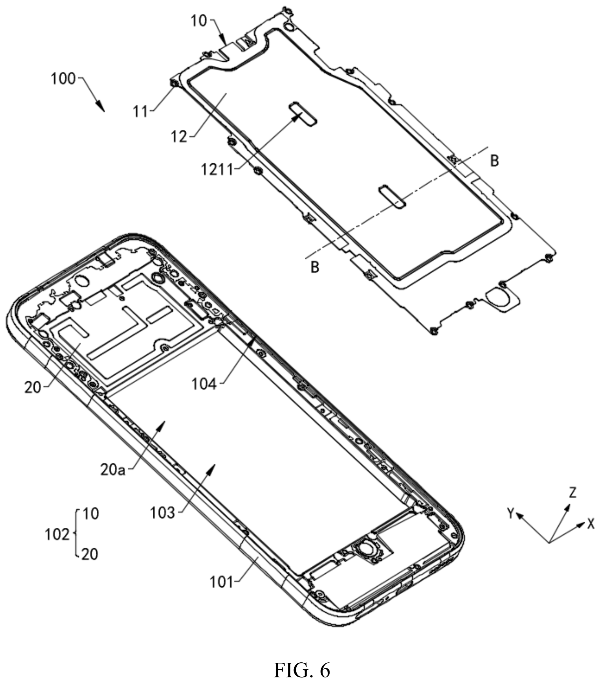

FIG. 6 is a partial exploded view of the middle frame 100 shown in FIG. 2 in an implementation.

As shown in FIG. 5 and FIG. 6, the middle plate 102 of the middle frame 100 includes a heat dissipation plate 10 and a support plate 20. It may be understood that the support plate 20 may be of a plate structure. In some embodiments, the support plate 20 is fastened to the inner side surface 104 of the side frame 101. For example, the support plate 20 and the side frame 101 may form an integrated mechanical part by using an injection molding process.

In some embodiments, the support plate 20 is provided with a hollow region 20a. The heat dissipation plate 10 is fastened to the support plate 20. The heat dissipation plate 10 covers the hollow region 20a of the support plate 20 and encloses the battery compartment 103. With reference to FIG. 4, the battery 500 is fastened to the heat dissipation plate 10. It may be understood that the heat dissipation plate 10 can dissipate heat from the battery 500, and can also support the battery 500. With reference to FIG. 3, a part of the middle of the display 300 is fastened to the support plate 20, and a part of the middle of the display 300 is fastened to the heat dissipation plate 10. The support plate 20 and the heat dissipation plate 10 jointly support the display 300. In addition, the heat dissipation plate 10 can further dissipate heat from the display 300.

As shown in FIG. 4 and FIG. 5, the support plate 20 may be provided with the accommodation groove 105. In this case, the circuit board 400 is fastened to the support plate 20. In some implementations, the accommodation groove 105 may alternatively be enclosed by the support plate 20 and the heat dissipation plate 10. In this case, the circuit board 400 may be fastened to the heat dissipation plate 10. The heat dissipation plate 10 can dissipate heat from the circuit board 400.

The foregoing describes connection relationships between the display 300, the battery 500, the circuit board 400, and the support plate 20 and the heat dissipation plate 10 of the middle plate 102 with reference to the related accompanying drawings. The following describes a structure of the heat dissipation plate 10 in detail with reference to related accompanying drawings.

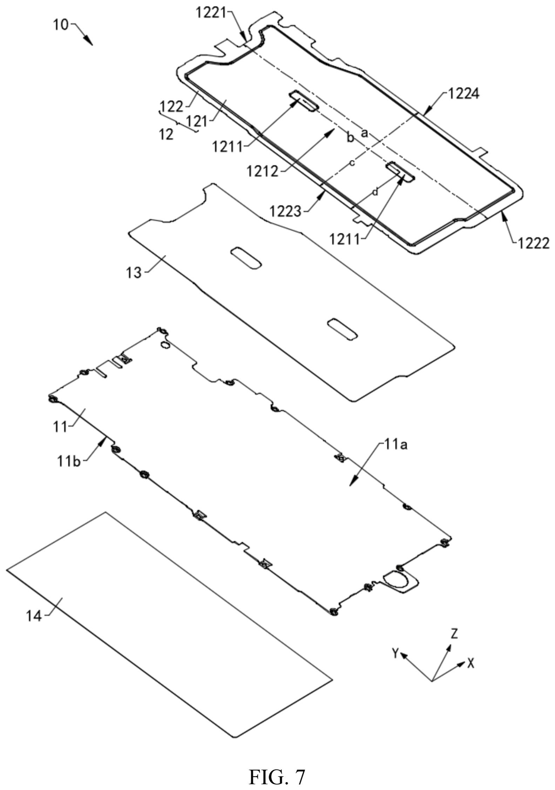

FIG. 7 is a partial exploded view of the heat dissipation plate 10 shown in FIG. 6 in an implementation.

As shown in FIG. 7, the heat dissipation plate 10 includes a first cover 11, a second cover 12, a capillary structure 13, and a cooling medium 14. It may be understood that FIG. 7 merely schematically shows the cooling medium 14 by using a rectangular box.

In some embodiments, a material of the first cover 11 may be a high-strength material. For example, the first cover 11 may be made of a plurality of layers of materials. For example, the first cover 11 may be made of two layers of materials. A first layer of material may be stainless steel. A second layer of material may be copper or a copper alloy.

In some embodiments, a thickness of the first cover 11 in the Z-axis direction may be within a range of 0.15 millimeter to 0.2 millimeter. For example, the thickness of the first cover 11 in the Z-axis direction may be 0.15 millimeter, 0.16 millimeter, 0.18 millimeter, or 0.2 millimeter.

In some embodiments, a material of the second cover 12 may also be a high-strength material. For example, the second cover 12 may be made of a plurality of layers of materials. For example, the second cover 12 may be made of two layers of materials. A first layer of material may be stainless steel. A second layer of material may be copper or a copper alloy.

In some embodiments, a thickness of the second cover 12 in the Z-axis direction may be within a range of 0.04 millimeter to 0.08 millimeter. For example, the thickness of the first cover 11 in the Z-axis direction may be 0.04 millimeter, 0.05 millimeter, 0.06 millimeter, 0.07 millimeter, or 0.08 millimeter.

In some embodiments, the capillary structure 13 may be a metal mechanical part having a porous structure. For example, the capillary structure 13 may be copper mesh, copper fiber, or copper foam.

In some embodiments, the cooling medium 14 may be water, methanol, acetone, or the like.

As shown in FIG. 7, the first cover 11 may include a first surface 11a and a first surface 11b that face away from each other.

As shown in FIG. 7, the second cover 12 may include a middle region 121 and an edge region 122 disposed around the middle region 121. In some embodiments, a width of the edge region 122 of the second cover 12 may be within a range of 1 millimeter to 6 millimeters.

In addition, the middle region 121 of the second cover 12 may include a shaping region 1211 and an accommodation region 1212 connected to the shaping region 1211. In some embodiments, the accommodation region 1212 is disposed around the shaping region 1211. It may be understood that the accommodation region 1212 may be disposed around a part of the shaping region 1211, or may be disposed around the entire shaping region 1211. In some embodiments, there are two shaping regions 1211. In some implementations, actual shapes, actual sizes, actual positions, and an actual quantity of shaping regions 1211 are not specifically limited in this application.

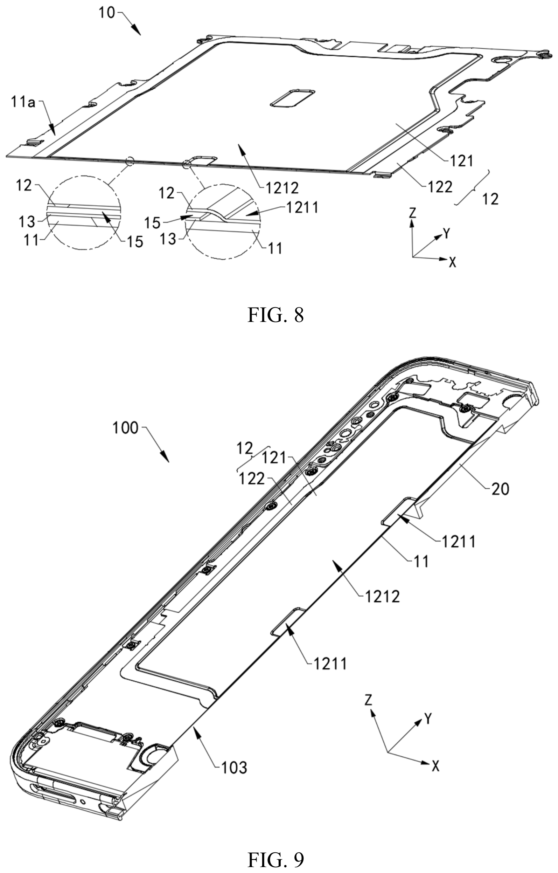

FIG. 8 is a partial cross-sectional view of the heat dissipation plate 10 shown in FIG. 6 and cut along B-B in some embodiments.

As shown in FIG. 7 and FIG. 8, the second cover 12 may be disposed opposite to the first cover 11. The edge region 122 of the second cover 12 may be fastened to the first surface 11a of the first cover 11. In other words, the edge region 122 of the second cover 12 may be fastened to the first cover 11. Space between the second cover 12 and the first cover 11 may form sealed space. The accommodation region 1212 of the middle region 121 of the second cover 12 and the first cover 11 may be spaced from each other and enclose an accommodation cavity 15.

In some embodiments, the shaping region 1211 of the middle region 121 of the second cover 12 may be concave toward the first cover 11 and fastened to the first surface 11a of the first cover 11. In other words, the shaping region 1211 of the middle region 121 of the second cover 12 may be fastened to the first cover 11. In this way, in comparison with a solution in which at least a part of the first cover 11 is convex toward the shaping region 1211 and fastened to the shaping region 1211, the first cover 11 in this implementation has high flatness, which facilitates stable connection between the first cover 11 and another mechanical part. In some implementations, the first cover 11 is convex toward the shaping region 1211 and fastened to the shaping region 1211.

In some embodiments, the edge region 122 of the second cover 12 may be fastened to the first cover 11 by using a welding process (for example, brazing). In this way, connection between the second cover 12 and the first cover 11 is more stable and secure. In addition, the accommodation cavity 15 has better sealing performance.

In some embodiments, the shaping region 1211 of the middle region 121 of the second cover 12 may also be fastened to the first cover 11 by using a welding process (for example, brazing). In this way, connection between the shaping region 1211 and the first cover 11 is more stable and secure.

As shown in FIG. 7 and FIG. 8, the capillary structure 13 is fastened to the first surface 11a of the first cover 11, and the capillary structure 13 is located in the accommodation cavity 15. In some embodiments, the capillary structure 13 may be fastened to the first cover 11 by using a welding process. In this way, connection between the capillary structure 13 and the first cover 11 is more stable and secure.

As shown in FIG. 7 and FIG. 8, the cooling medium 14 may be disposed in the accommodation cavity 15. The capillary structure 13 may be immersed in the cooling medium 14.

As shown in FIG. 5 and FIG. 6, the first cover 11 of the heat dissipation plate 10 may be fastened to the support plate 20. The first cover 11 may cover the hollow region 20a of the support plate 20 and enclose the battery compartment 103.

As shown in FIG. 4 and FIG. 5, the battery 500 may be fastened to the first cover 11 and located in the battery compartment 103. In this case, heat generated by the battery 500 can be transmitted to the heat dissipation plate 10, and heat is dissipated by using the heat dissipation plate 10. In addition, a support plate 20 is no longer disposed between the battery 500 and the heat dissipation plate 10. In this way, in the thickness direction of the electronic device 1000, a thickness of the support plate 20 can be eliminated, which facilitates thinning of the electronic device 1000.

In some embodiments, the battery 500 may be fastened to the first cover 11 by using a battery adhesive (for example, a double-sided tape).

As shown in FIG. 4 and FIG. 5, the circuit board 400 may be fastened to the support plate 20 and located on a side that is of the support plate 20 and that is away from the first cover 11. Heat generated by the circuit board 400 may be transmitted to the first cover 11 through the support plate 20. In this way, the first cover 11 can also dissipate the heat generated by the circuit board 400.

As shown in FIG. 3, a part of the middle of the display 300 may be fastened to the second cover 12. In some embodiments, the part of the middle of the display 300 may be fastened to the second cover 12 by using a display adhesive (not shown in the figure). In some implementations, the middle of the display 300 may not be fastened to the second cover 12.

In some embodiments, a display insulation member 80 may be disposed between a part of the middle of the display 300 and the second cover 12, to separate the middle of the display 300 from the second cover 12, so as to avoid electrical connection between the display 300 and the second cover 12.

As shown in FIG. 7 and FIG. 8, the shaping region 1211 may be disposed in the middle region 121 of the second cover 12, and the shaping region 1211 is fastened to the first surface 11a of the first cover 11, so that the shaping region 1211 is used to perform flatness shaping on the accommodation region 1212 and the first cover 11.

It may be understood that, if the accommodation region 1212 of the second cover 12 is convex away from the first cover 11, the accommodation region 1212 of the second cover 12 has poor flatness. In this case, when the heat dissipation plate 10 is used in the electronic device 1000, the second cover 12 of the heat dissipation plate 10 is likely to push against the display, causing damage to the display 300. In an implementation of this application, a jig may be used to apply an acting force in a first direction to the shaping region 1211 of the second cover 12, so that the accommodation region 1212 of the second cover 12 is no longer convex away from the first cover 11 under a pulling force. In other words, the accommodation region 1212 of the second cover 12 can be pulled flat, and the accommodation region 1212 of the second cover 12 can be adjusted to good flatness. In other words, flatness of the accommodation region 1212 of the second cover 12 can be adjusted to a specification. This greatly improves a yield in flatness of the heat dissipation plate 10. In this way, the second cover 12 of the heat dissipation plate 10 is not likely to push against the display, to ensure that the display 300 has good reliability. The first direction may be a direction in which the second cover 12 faces the first cover 11. In addition, the shaping region 1211 of the second cover 12 is fastened to the first cover 11, and no capillary structure 13 is disposed between the shaping region 1211 and the first cover 11. In this case, the shaping region 1211 can bear a large acting force, to meet a requirement for flatness of the heat dissipation plate 10. In other words, when the acting force in the first direction is applied to the shaping region 1211 of the second cover 12, the second cover 12 does not deform toward the first cover 11 and squeeze the capillary structure 13, to avoid damage to the capillary structure 13.

It may be understood that, if the first cover 11 is convex away from the second cover 12, the first cover 11 also has poor flatness. In this case, when the heat dissipation plate 10 is used in the electronic device 1000, because the first cover 11 has poor flatness, both the battery 500 and the first cover 11 of the heat dissipation plate 10 are poorly bonded to the battery adhesive, and connection is not secure. Consequently, a problem such as debonding of the battery 500 is likely to occur. In an implementation of this application, a jig may be used to apply an acting force in a second direction to the shaping region 1211 of the second cover 12, so that the first cover 11 is no longer convex away from the second cover 12 under a pulling force. In other words, the first cover 11 can be pulled flat, and the first cover 11 can be restored to good flatness. In other words, flatness of the first cover 11 can be adjusted to a specification. This greatly improves a yield in flatness of the heat dissipation plate 10. In this way, both the battery 500 and the first cover 11 of the heat dissipation plate 10 are well bonded to the battery adhesive, and the battery 500 is not prone to a problem of debonding. The second direction may be a direction in which the first cover 11 faces the second cover 12.

As shown in FIG. 7, there are a plurality of shaping regions 1211. In some embodiments, there may be two shaping regions 1211. The two shaping regions 1211 may be spaced from each other in a length direction of the heat dissipation plate 10 (that is, the Y-axis direction). In this way, the two shaping regions 1211 can be responsible for flatness shaping of different positions in the accommodation region 1212, to ensure that a large part of the accommodation region 1212 can be flattened once the large part deforms and protrudes.

As shown in FIG. 7, the edge region 122 of the second cover 12 may include a first edge 1221 and a second edge 1222 that are arranged in the length direction of the heat dissipation plate 10 (that is, the Y-axis direction).

In some embodiments, a shortest distance between the first edge 1221 and the second edge 1222 is a, and a distance between a center of a 1^{st} shaping region 1211 and a center of a 2^{nd} shaping region 1211 is b, where a and b satisfy 0.25a≤b≤0.4a. For example, b may be equal to 0.25a, 0.3a, 0.35a, or 0.4a. It may be understood that, when a and b satisfy 0.25a≤b≤0.4a, the 1^{st} shaping region 1211 and the 2^{nd} shaping region 1211 can cooperate with each other, to implement flatness shaping of most positions in the accommodation region 1212.

In some embodiments, the edge region 122 of the second cover 12 includes a third edge 1223 and a fourth edge 1224 that are arranged in a width direction of the heat dissipation plate 10 (that is, the X-axis direction), the third edge 1223 and the fourth edge 1224 are connected between the first edge 1221 and the second edge 1222, and a shortest distance between the third edge 1223 and the fourth edge 1224 is c.

A distance between the center of the shaping region 1211 and the third edge 1223 is d, where c and d satisfy 0.4c≤d≤0.6c. For example, d may be equal to 0.4c, 0.5c, 0.55c, or 0.6c.

It may be understood that, when c and d satisfy 0.4c≤d≤0.6c, the shaping regions 1211 can implement flatness shaping of most positions in the accommodation region 1212.

FIG. 9 is a partial cross-sectional view of the middle frame 100 shown in FIG. 2 and cut along C-C in some embodiments.

As shown in FIG. 9, for example, the 1^{st} shaping region 1211 may be directly opposite to a boundary between the battery compartment 103 and the support plate 20. In this way, the 1^{st} shaping region 1211 can perform flatness shaping on a partial region that is of the heat dissipation plate 10 and that is directly opposite to the battery compartment 103, so that flatness of the partial region that is of the heat dissipation plate 10 and that is directly opposite to the battery compartment 103 can be adjusted to a specification, to greatly improve a yield in flatness of the partial region that is of the heat dissipation plate 10 and that is directly opposite to the battery compartment 103. In this way, both the battery 500 and the heat dissipation plate 10 are well bonded to the battery adhesive, and the battery 500 is not prone to a problem of debonding. The 1^{st} shaping region 1211 can also perform flatness shaping on a partial region that is of the heat dissipation plate 10 and that is directly opposite to the support plate 20, so that flatness of the partial region that is of the heat dissipation plate 10 and that is directly opposite to the support plate 20 can be adjusted to a specification, to greatly improve a yield in flatness of the partial region that is of the heat dissipation plate 10 and that is directly opposite to the support plate 20. This can resolve a problem that the support plate 20 squeezes the heat dissipation plate 10 due to poor flatness and the heat dissipation plate 10 deforms and squeezes the display 300. The display 300 in implementations of this application has good reliability.

As shown in FIG. 9, for example, the 2^{nd} shaping region 1211 may be directly opposite to the battery compartment 103. In this way, the 2^{nd} shaping region 1211 can better perform flatness shaping on a region that is of the heat dissipation plate 10 and that is directly opposite to the battery compartment 103, so that flatness of the heat dissipation plate 10 can be adjusted to a specification, to greatly improve a yield in flatness of the heat dissipation plate 10. In this way, both the battery 500 and the first cover 11 of the heat dissipation plate 10 are well bonded to the battery adhesive, and the battery 500 is not prone to a problem of debonding.

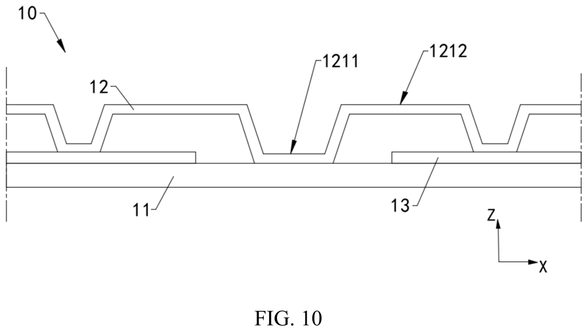

FIG. 10 is a partial cross-sectional view of the heat dissipation plate 10 shown in FIG. 6 and cut along B-B in some other embodiments.

As shown in FIG. 10, in some embodiments, a part of the accommodation region 1212 of the second cover 12 may be concave toward the first cover 11, and may be fastened to the capillary structure 13. In this way, the accommodation region 1212 of the second cover 12 is approximately bent, and the second cover 12 has good strength. It may be understood that a structure of the accommodation region 1212 of the second cover 12 in implementations of this application can resolve a problem that the accommodation region 1212 of the second cover 12 has low strength due to a small thickness.

It may be understood that, although FIG. 10 shows that the capillary structure 13 and the shaping region 1211 of the second cover 12 are separated from each other, in some implementations, the capillary structure 13 may alternatively be connected to the shaping region 1211 of the second cover 12.

It may be understood that, with reference to the related accompanying drawings, the foregoing provides a description: the heat dissipation plate 10 can support the battery 500 and the display 300, and can also dissipate heat from the battery 500 and the display 300. It is clear that reliability of connection between the heat dissipation plate 10 and the support plate 20 is particularly important. With reference to related accompanying drawings, the following specifically describes several manners of fastening the heat dissipation plate 10 to the middle plate 102, to ensure that the heat dissipation plate 10 can be stably and securely connected to the support plate 20.

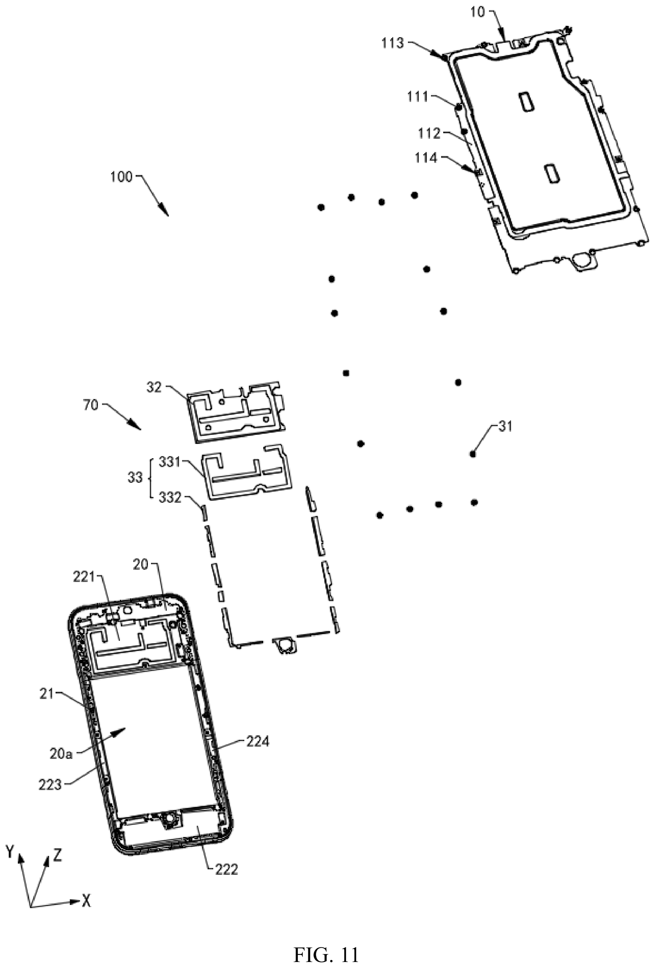

FIG. 11 is a partial exploded view of the middle frame 100 shown in FIG. 2 in another implementation.

As shown in FIG. 11, the heat dissipation plate 10 may be fastened to the support plate 20 through cooperation between a fastener 31, an adhesive 32, and an adhesive layer 33. The fastener 31 may be a bolt, a screw, a pin, or the like. The adhesive 32 may be a double-sided tape. The adhesive layer 33 may be a structure formed by curing glue. The glue may be formed between the heat dissipation plate 10 and the support plate 20 by using a dispensing process.

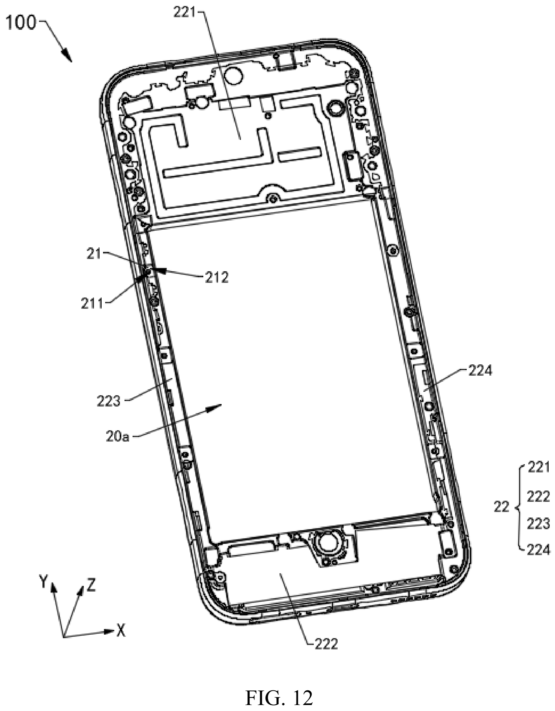

FIG. 12 is an enlarged view of a part of the middle frame 100 shown in FIG. 11 in an implementation.

As shown in FIG. 12, the support plate 20 may include a first connection region 21 and a second connection region 22. The second connection region 22 is fastened to the first connection region 21.

In some embodiments, there may be one or more first connection regions 21, and there may be one or more second connection regions 22. An example in which there are a plurality of first connection regions 21 and one second connection region 22 is used below for description.

In some embodiments, the second connection region 22 may be disposed around the plurality of first connection regions 21. In addition, the plurality of first connection regions 21 may be distributed close to an edge of the second connection region.

In some implementations, quantities, shapes, sizes, and positions of first connection regions 21 and second connection regions 22 of the support plate 20 are not specifically limited in this application.

In some embodiments, the second connection region 22 may include a first plate region 221, a second plate region 222, and a first edge region 223 and a second edge region 224 that are disposed opposite to each other. The first edge region 223 and the second edge region 224 may be connected between the first plate region 221 and the second plate region 222. The first edge region 223, the second edge region 224, the first plate region 221, and the second plate region 222 may be disposed around the hollow region 20a. In addition, the first edge region 223 and the second edge region 224 may be arranged in the width direction of the heat dissipation plate 10 (that is, the X-axis direction). The first plate region 221 and the second plate region 222 may be arranged in the length direction of the heat dissipation plate 10 (that is, the Y-axis direction). It may be understood that, in a width direction of the middle frame 100, sizes of both the first edge region 223 and the second edge region 224 may be less than sizes of the first plate region 221 and the second plate region 222.

It may be understood that, when there are a plurality of first connection regions 21, the first connection regions 21 may be spaced from each other in the first plate region 221, the second plate region 222, the first edge region 223, and the second edge region 224 of the second connection region 22.

As shown in FIG. 11, in some embodiments, the first cover 11 of the heat dissipation plate 10 may include a third connection region 111 and a fourth connection region 112. The fourth connection region 112 is fastened to the third connection region 111.

For example, a quantity of third connection regions 111 matches the quantity of first connection regions 21, and a quantity of fourth connection regions 112 matches the quantity of second connection regions 22. For example, there are a plurality of third connection regions 111 and one fourth connection region 112. In some implementations, quantities, shapes, sizes, and positions of third connection regions 111 and fourth connection regions 112 of the first cover 11 of the heat dissipation plate 10 are not specifically limited in this application.

As shown in FIG. 11 and FIG. 12, the third connection region 111 of the heat dissipation plate 10 may be fastened to the first connection region 21 of the support plate 20 by using the fastener 31. The fourth connection region 112 of the heat dissipation plate 10 is fastened to the second connection region 22 of the support plate 20 by using the adhesive 32 and the adhesive layer 33. In this way, the heat dissipation plate 10 may be fastened to the support plate 20 through cooperation between the fastener 31, the adhesive 32, and the adhesive layer 33. In this case, connection between the heat dissipation plate 10 and the support plate 20 is more secure and stable, and the heat dissipation plate 10 can better support the battery 500 and the display 300.

First, as shown in FIG. 11 and FIG. 12, the third connection region 111 of the heat dissipation plate 10 may be fastened to the first connection region 21 of the support plate 20 by using the fastener 31.

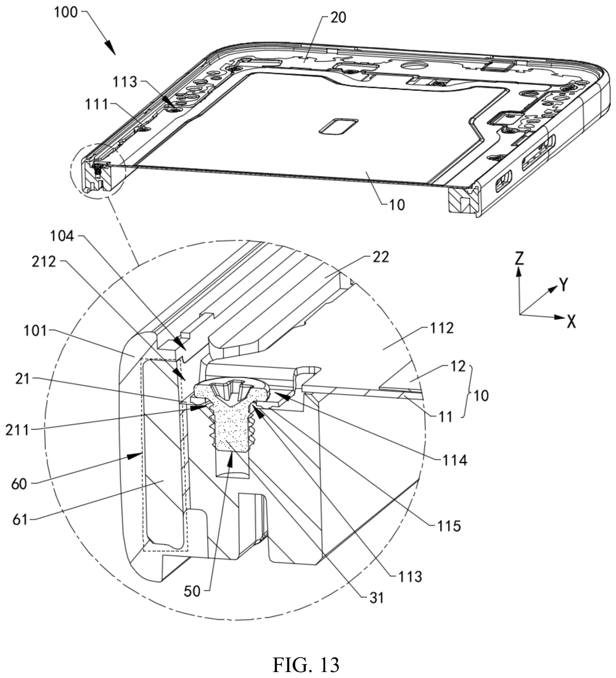

FIG. 13 is a partial cross-sectional view of the middle frame 100 shown in FIG. 2 and cut along D-D in some embodiments.

As shown in FIG. 13, for example, the first connection region 21 of the support plate 20 may be provided with a fastening hole 211. The third connection region 111 of the first cover 11 may also be provided with a fastening hole 113. The fastening hole 113 of the first cover 11 may be provided opposite to the fastening hole 211 of the support plate 20. The middle frame 100 may further include the fastener 31. The fastener 31 sequentially passes through the fastening hole 211 of the support plate 20 and the fastening hole 113 of the first cover 11, so that the heat dissipation plate 10 is locked on the support plate 20. In this case, connection between the heat dissipation plate 10 and the support plate 20 is more secure and stable.

It may be understood that when there are a plurality of first connection regions 21, there may also be a plurality of fastening holes 211 of the support plate 20. A quantity of fastening holes 113 of the first cover 11 may match a quantity of fastening holes 211 of the support plate 20. In other words, there are also a plurality of fastening holes 113 of the first cover 11. In this case, the plurality of fastening holes of the first cover 11 are provided opposite to the plurality of fastening holes of the support plate 20 in a one-to-one correspondence. A plurality of fasteners 31 pass through the plurality of fastening holes of the first cover 11 and the plurality of fastening holes of the support plate 20 in a one-to-one correspondence.

For example, the first connection region 21 of the support plate 20 may be provided with a first groove 212. The fastening hole 211 of the support plate 20 may be located in the first groove 212. The fastening hole 211 of the support plate 20 may form an opening on a bottom wall of the first groove 212. In addition, at least a part of the third connection region 111 of the first cover 11 may be concave toward the bottom wall of the first groove 212 to form a second groove 114. The fastening hole 113 of the first cover 11 may be located in the second groove 114. The fastening hole 113 of the first cover 11 may form an opening on a bottom wall of the second groove 114.

It may be understood that, after the fastener 31 passes through the fastening hole 113 of the first cover 11 and the fastening hole 211 of the support plate 20, a part (for example, a nut) of the fastener 31 may be located in the second groove 114. In this way, the fastener 31 and the display 300 can avoid each other, to avoid a problem that the fastener 31 pushes against the display. In addition, when the electronic device 1000 is impacted, the fastener 31 does not impact the display 300, to prevent the display 300 from impacting the fastener 31 and producing a display defect such as a broken bright spot.

For example, the second groove 114 of the first cover 11 may be formed by using a stamping process.

For example, when there are a plurality of fasteners 31, a quantity of first grooves 212 of the support plate 20 and a quantity of second grooves 114 of the first cover 11 may match a quantity of fasteners 31. In this case, nuts of the plurality of fasteners 31 are disposed in a plurality of second grooves 114 in a one-to-one correspondence.

For example, the third connection region 111 of the first cover 11 may include a plurality of protrusions 115 that are spaced from each other. The plurality of protrusions 115 may be disposed around the fastening hole 113 of the first cover 11. When the first cover 11 is locked on the support plate 20 by using the fastener 31, the plurality of protrusions 115 may abut against the first connection region 21 of the support plate 20. In this way, connection between the first cover 11 and the support plate 20 is closer and more secure.

Second, as shown in FIG. 11 and FIG. 12, the fourth connection region 112 of the heat dissipation plate 10 may be fastened to the second connection region 22 of the support plate 20 through cooperation between the adhesive 32 and the adhesive layer 33.

It may be understood that, in some implementations, in the width direction of the middle frame 100, the sizes of both the first plate region 221 and the second plate region 222 of the second connection region 22 are greater than the sizes of the first edge region 223 and the second edge region 224 of the second connection region 22, and a bonding force between the adhesive and the heat dissipation plate 10 and a bonding force between the adhesive and the support plate 20 are closely related to a size of the support plate 20 in the width direction of the middle frame 100. Therefore, the following separately describes a manner of fastening the heat dissipation plate 10 to the first plate region 221 and the second plate region 222, and a manner of fastening the heat dissipation plate 10 to the first edge region 223 and the second edge region 224. In addition, in some implementations, in the width direction of the middle frame 100, the sizes of the second plate region 222 and the first plate region 221 of the support plate 20 are approximately the same. Therefore, the following uses a manner of fastening the heat dissipation plate 10 to the first plate region 221 of the support plate 20 as an example for description. For a manner of fastening the heat dissipation plate 10 to the second plate region 222 of the support plate 20, refer to the manner of fastening the heat dissipation plate 10 to the first plate region 221 of the support plate 20. Certainly, the second plate region 222 of the support plate 20 and the heat dissipation plate 10 may alternatively be fastened together in another fastening manner. Details are not described herein. Similarly, the following uses a manner of fastening the heat dissipation plate 10 to the first edge region 223 of the support plate 20 as an example for description.

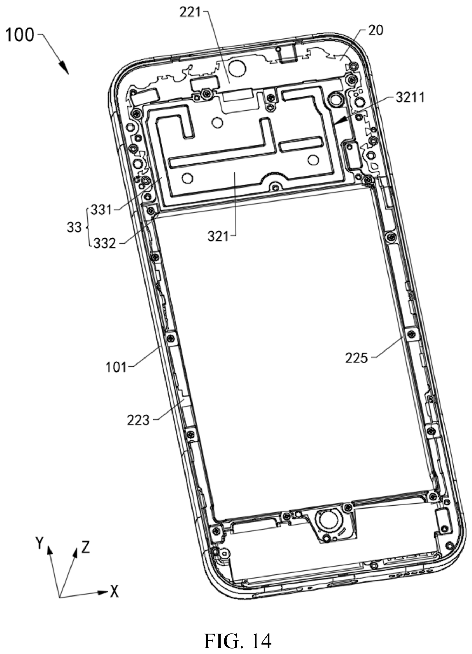

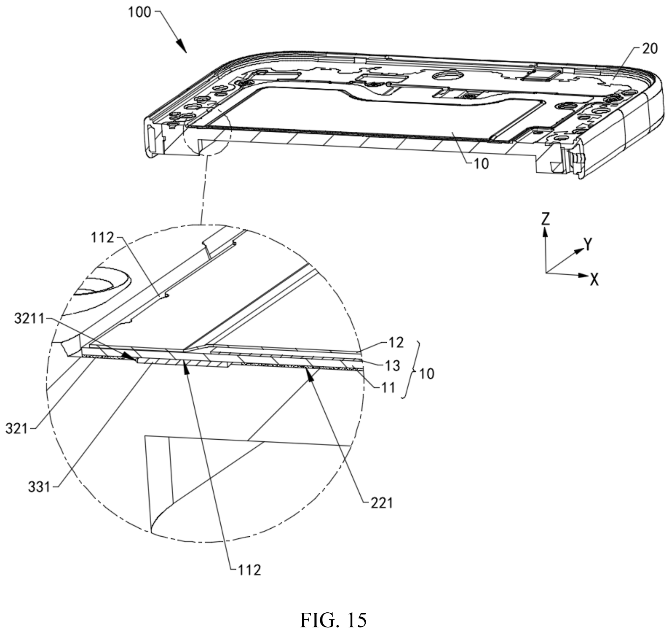

FIG. 14 is a diagram of a partial structure of the middle frame 100 shown in FIG. 2 in an implementation. FIG. 15 is a partial cross-sectional view of the middle frame 100 shown in FIG. 2 and cut along E-E in some embodiments.

As shown in FIG. 14 and FIG. 15, the fourth connection region 112 of the first cover 11 of the heat dissipation plate 10 may be fastened to the first plate region 221 of the support plate 20 through cooperation between a first adhesive 321 and a first adhesive layer 331.

For example, the adhesive 32 may include the first adhesive 321. The first adhesive 321 is bonded between the fourth connection region 112 of the first cover 11 and the first plate region 221 of the support plate 20. It may be understood that, because the first adhesive 321 has good adhesion and good impact resistance, connection between the first cover 11 of the heat dissipation plate 10 and the support plate 20 is secure, so that a reliability test requirement can be better met.

For example, the first adhesive 321 may be provided with a dispensing hole 3211. The adhesive layer 33 may further include the first adhesive layer 331. The first adhesive layer 331 may be disposed in the dispensing hole 3211. The first adhesive layer 331 may also be bonded between the fourth connection region 112 of the first cover 11 and the first plate region 221 of the support plate 20. It may be understood that, because the first adhesive layer 331 has stronger adhesion, the first adhesive layer 331 can fasten the heat dissipation plate 10 to the support plate 20 more securely. In this way, connection between the heat dissipation plate 10 and the support plate 20 is more secure, so that the reliability test requirement can be better met.

It may be understood that the first adhesive 321 may be provided with the dispensing hole 3211 (namely, dispensing space) for the first adhesive layer 331, to prevent the glue from overflowing in a dispensing procedure. In addition, in a procedure of fastening the heat dissipation plate 10 to the support plate 20, the first adhesive 321 can well support the heat dissipation plate 10, to prevent the heat dissipation plate 10 from crushing the glue in a press-fit procedure, and ensure stability of connection between the heat dissipation plate 10 and the support plate 20.

It may be understood that the fourth connection region 112 of the heat dissipation plate 10 may be fastened to the first plate region 221 of the support plate 20 not only through cooperation between the first adhesive 321 and the first adhesive layer 331. In some implementations, the fourth connection region 112 of the heat dissipation plate 10 may alternatively be fastened to the first plate region 221 of the support plate 20 by only using the first adhesive 321, or may be fastened to the first plate region 221 of the support plate 20 by only using the first adhesive layer 331. In some implementations, the heat dissipation plate 10 may alternatively be fastened to the first plate region 221 of the support plate 20 in another fastening manner. This is not specifically limited in this application.

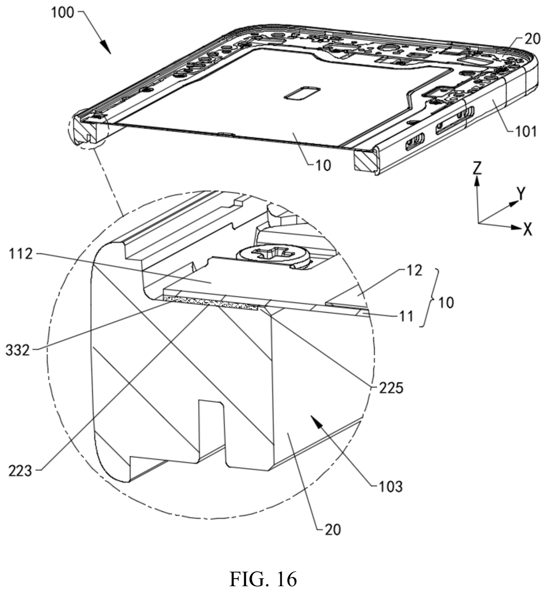

FIG. 16 is a partial cross-sectional view of the middle frame 100 shown in FIG. 2 and cut along F-F in some embodiments.

As shown in FIG. 14 and FIG. 16, the fourth connection region 112 of the first cover 11 of the heat dissipation plate 10 may be further fastened to the first edge region 223 of the support plate 20 by using a second adhesive layer 332.

For example, a first barrier wall 225 may protrude from the first edge region 223 of the second connection region 22 of the support plate 20. The first barrier wall 225 may be located at an end that is of the first edge region 223 and that is close to the battery compartment 103. The first barrier wall 225, the first edge region 223 of the support plate 20, and the side frame 101 may enclose a dispensing groove. The adhesive layer further includes the second adhesive layer 332. The second adhesive layer 332 may be bonded between the fourth connection region 112 of the first cover 11 and the first edge region 223 of the support plate 20. It may be understood that, because the second adhesive layer 332 has stronger adhesion, the second adhesive can fasten the heat dissipation plate 10 to the first edge region 223 of the support plate 20 more securely. In this way, connection between the heat dissipation plate 10 and the support plate 20 is more secure, so that the reliability test requirement can be better met.

It may be understood that, the first barrier wall 225 can prevent the glue from overflowing the dispensing groove and flowing into the battery compartment 103 in a dispensing procedure. In addition, a thickness of the adhesive layer may be flexibly controlled by setting a height of the first barrier wall 225, to ensure that the second adhesive layer 332 has a sufficient adhesive height, so that the heat dissipation plate 10 can be stably connected to the support plate.

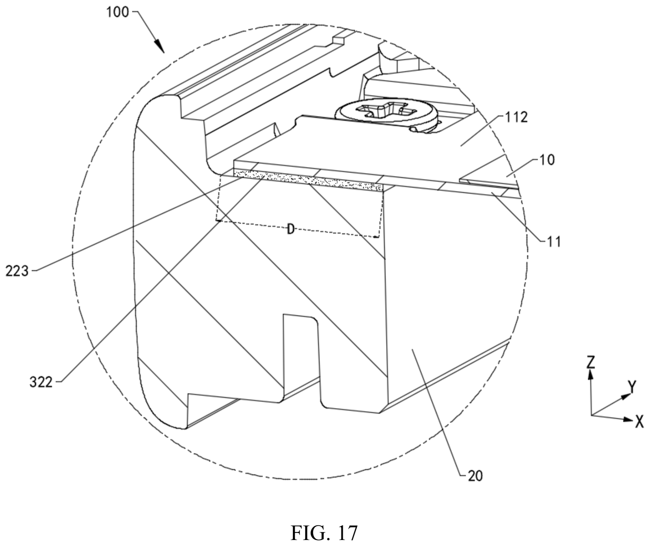

FIG. 17 is a partial cross-sectional view of the middle frame 100 shown in FIG. 2 and cut along F-F in some other embodiments.

As shown in FIG. 17, the fourth connection region 112 of the first cover 11 of the heat dissipation plate 10 may alternatively be fastened to the first edge region 223 of the support plate 20 by using a second adhesive 322.

In some embodiments, in the width direction of the middle frame 100 (that is, the X-axis direction), a width D of the first edge region 223 of the support plate 20 may be greater than or equal to 1.5 millimeters. For example, the width D of the first edge region 223 may be 1.5 millimeters, 2 millimeters, 2.5 millimeters, 2.6 millimeters, 2.8 millimeters, 3.1 millimeters, or 4 millimeters. In some implementations, the width D of the first edge region 223 of the support plate 20 may not be specifically limited.

For example, the adhesive 32 includes the second adhesive 322. The second adhesive 322 may be bonded between the fourth connection region 112 of the first cover 11 and the first edge region 223 of the support plate 20. In this case, the first cover 11 of the heat dissipation plate 10 may be fastened to the first edge region 223 of the support plate 20 by using the second adhesive 322. In this way, because the second adhesive 322 has good adhesion and good impact resistance, connection between the first cover 11 of the heat dissipation plate 10 and the first edge region 223 of the support plate 20 is more secure, so that the reliability test requirement can be better met.

It may be understood that, in comparison with the solution in which the fourth connection region 112 of the first cover 11 is fastened to the first edge region 223 of the support plate 20 by using the second adhesive layer 332, in this implementation of this application, the fourth connection region 112 of the first cover 11 may be fastened to the first edge region 223 of the support plate 20 by using the second adhesive 322, and therefore a dispensing process may not be used in this implementation of this application. This can avoid a risk of glue overflow, and can eliminate a need for the dispensing process, to reduce process costs. In addition, the first edge region 223 of the support plate 20 may not be provided with the first barrier wall 225. In this way, the first edge region 223 of the support plate 20 has a simple structure and is easy to produce. In addition, the first edge region 223 of the support plate 20 has high flatness, which facilitates connection between the first cover 11 of the heat dissipation plate 10 and the support plate 20.

In some implementations, the fourth connection region 112 of the first cover 11 may alternatively be fastened to the first edge region 223 of the support plate 20 through cooperation between the second adhesive 322 and the second adhesive layer 332. This is not specifically limited in this application.

It may be understood that, with reference to the related accompanying drawings, the foregoing specifically describes the solution in which the third connection region 111 of the heat dissipation plate 10 is fastened to the first connection region 21 of the support plate 20 by using the fastener 31, and the fourth connection region 112 of the heat dissipation plate 10 is fastened to the second connection region 22 of the support plate 20 by using the adhesive 32 and the adhesive layer 33. This solution can ensure that the heat dissipation plate 10 can be stably and securely connected to the support plate 20. With reference to related accompanying drawings, the following specifically describes several manners of fastening the third connection region 111 of the heat dissipation plate 10 to the first connection region 21 of the support plate 20.

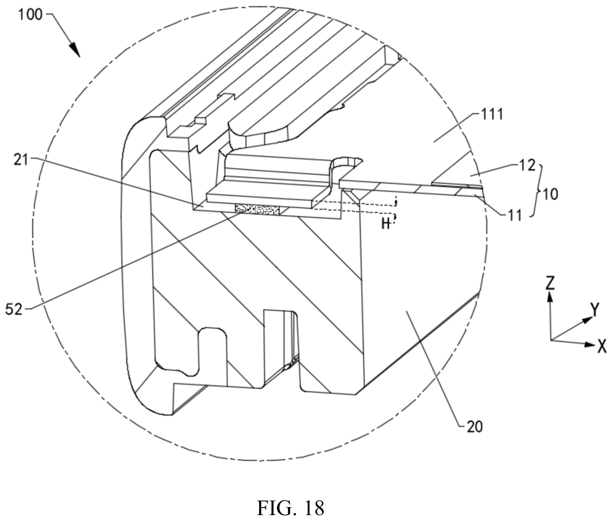

FIG. 18 is a partial cross-sectional view of the middle frame 100 shown in FIG. 2 and cut along D-D in some other embodiments.

As shown in FIG. 18, in some embodiments, the third connection region 111 of the heat dissipation plate 10 may be fastened to the first connection region 21 of the support plate 20 by using a welding joint 52. The welding joint 52 may be a structure formed between the heat dissipation plate 10 and the support plate 20 by using a welding process.

In some embodiments, a thickness H of the first cover 11 of the heat dissipation plate 10 may be less than or equal to 0.2 mm. For example, the thickness L of the first cover 11 may be 0.2 mm (millimeter), 0.15 mm (millimeter), 0.14 mm (millimeter), 0.13 mm (millimeter), 0.12 mm (millimeter), or 0.1 mm (millimeter). In some implementations, the thickness H of the first cover 11 may not be specifically limited.

For example, the third connection region 111 of the first cover 11 of the heat dissipation plate 10 may be fastened to the first connection region 21 of the support plate 20 by using a welding process. In this case, the welding joint 52 may be formed between the third connection region 111 of the first cover 11 and the first connection region 21 of the support plate 20.

It may be understood that, in comparison with the solution in which the third connection region 111 of the heat dissipation plate 10 is fastened to the first connection region 21 of the support plate 20 by using the fastener 31, in this implementation of this application, the third connection region 111 of the heat dissipation plate 10 is fastened to the first connection region 21 of the support plate 20 by using the welding joint 52, so that structures of the third connection region 111 of the heat dissipation plate 10 and the first connection region 21 of the support plate 20 are not prone to damage caused by providing an opening, to ensure that the heat dissipation plate 10 and the support plate 20 have good structure strength.

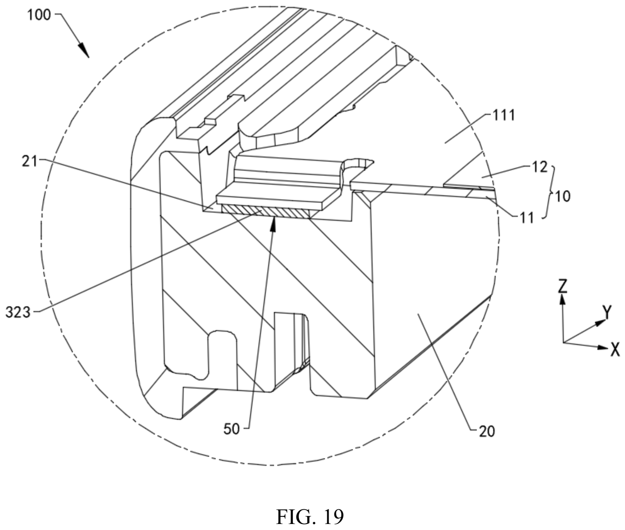

FIG. 19 is a partial cross-sectional view of the middle frame 100 shown in FIG. 2 and cut along D-D in still some embodiments.

As shown in FIG. 19, in some embodiments, the third connection region 111 of the heat dissipation plate 10 may be fastened to the first connection region 21 of the support plate 20 by using a third adhesive 323. The third adhesive 323 may be a double-sided tape.

In some embodiments, the middle frame 100 may include the third adhesive 323. The third adhesive 323 may be bonded between the third connection region 111 of the heat dissipation plate 10 and the first connection region 21 of the support plate 20. In this case, the third connection region 111 of the heat dissipation plate 10 may be fastened to the first connection region 21 of the support plate 20 by using the third adhesive 323. In this way, because the third adhesive 323 has good adhesion and good impact resistance, connection between the first cover 11 of the heat dissipation plate 10 and the support plate 20 is more secure, so that the reliability test requirement can be better met.

With reference to the related accompanying drawings, the foregoing specifically describes several manners of fastening the heat dissipation plate 10 to the middle plate 102. It may be understood that, because the heat dissipation plate 10 needs to support the battery 500 and the display 300 and dissipate heat, a material of the heat dissipation plate 10 is generally a high-strength metal material. As a result, the heat dissipation plate 10 is likely to generate clutter to a surrounding antenna 60, severely affecting performance of the antenna 60. Particularly, when the heat dissipation plate 10 has a large area, the heat dissipation plate 10 significantly affects the antenna 60. Based on this problem, embodiments of this application provide several manners of electrically connecting a part of the heat dissipation plate 10 to the support plate 20, to resolve the problem that the heat dissipation plate 10 affects the performance of the antenna 60. In addition, embodiments of this application further provide several manners of insulating a part of the heat dissipation plate 10 from the support plate 20, to prevent a current from being grounded at a non-grounding position of the heat dissipation plate 10, so as to avoid excitation of a new magnetic field at the non-grounding position of the heat dissipation plate 10, so that the performance of the antenna 60 is not affected. First, with reference to related accompanying drawings, the following specifically describes several manners of grounding the heat dissipation plate 10.

As shown in FIG. 13, the electronic device 1000 may include an antenna 60. It may be understood that a radiator 61 of the antenna 60 may be configured to: when receiving a radio frequency signal, radiate a signal of the antenna 60 to the outside of the electronic device 1000 based on the radio frequency signal. In addition, the radiator 61 of the antenna 60 may be further configured to: receive a signal for the antenna 60 from the outside of the electronic device 1000, and convert the signal for the antenna 60 into a radio frequency signal. In some embodiments, a part of the side frame 101 may form the radiator 61 of the antenna 60. Alternatively, the radiator 61 of the antenna 60 may be fastened to the inner side surface 104 of the side frame 101.

It may be understood that, a quantity of antennas 60 may not be limited to one shown in FIG. 13, and there may be a plurality of antennas 60.

First, a part of the heat dissipation plate 10 is grounded, to prevent the heat dissipation plate 10 from generating clutter to the surrounding antenna 60, so that performance of the antenna 60 is not affected.

As shown in FIG. 13, the first connection region 21 of the support plate 20 is a grounding position for the antenna 60. In this case, the third connection region 111 of the heat dissipation plate 10 is located in a region with strong electric field strength. The third connection region 111 of the heat dissipation plate 10 is likely to generate clutter to the surrounding antenna 60, severely affecting the performance of the antenna 60.

In an implementation of this application, the third connection region 111 of the heat dissipation plate 10 may be fastened to the first connection region 21 of the support plate 20 by using the fastener 31. A material of the fastener 31 may include a conductive material. In this case, the fastener 31 may be a conductive member 50. It may be understood that, the material of the fastener 31 includes the conductive material, and the first connection region 21 of the support plate 20 is the grounding position for the antenna 60, so that the third connection region 111 of the heat dissipation plate 10 can be electrically connected to the first connection region 21 of the support plate 20 through the fastener 31. In other words, the third connection region 111 of the heat dissipation plate 10 can be grounded through the fastener 31. In this way, the heat dissipation plate 10 is not likely to generate clutter to the surrounding antenna 60, and therefore the performance of the antenna 60 is not affected.

It may be understood that the fastener 31 can securely fasten the third connection region 111 of the heat dissipation plate 10 to the first connection region 21 of the support plate 20, and can also securely electrically connect the third connection region 111 of the heat dissipation plate 10 to the first connection region 21 of the support plate 20. The fastener 31 has effect of "one thing for a plurality of purposes".

Second, the non-grounding position of the heat dissipation plate 10 is insulated from the support plate 20, to prevent a current of the antenna 60 from being grounded at the non-grounding position of the heat dissipation plate 10, so as to avoid excitation of a new magnetic field at the non-grounding position of the heat dissipation plate 10, so that the performance of the antenna 60 is not affected.

As shown inFIG. 11 and FIG. 12, the second connection region 22 of the support plate 20 is a non-grounding position for the antenna 60. In this case, the fourth connection region 112 that is of the heat dissipation plate 10 and that is fastened to the second connection region 22 of the support plate 20 is also a non-grounding position for the antenna 60.

In an implementation of this application, the fourth connection region 112 of the heat dissipation plate 10 may be fastened to the second connection region 22 of the support plate 20 through cooperation between the adhesive 32 and the adhesive layer 33. Materials of both the adhesive 32 and the adhesive layer 33 may include an insulating material. In this case, the adhesive 32 and the adhesive layer 33 may be an insulation member 70. It may be understood that, the materials of both the adhesive 32 and the adhesive layer 33 include the insulating material, so that the fourth connection region 112 of the heat dissipation plate 10 can be insulated from the second connection region 22 of the support plate 20. In this case, the current of the antenna 60 is not likely to be grounded at the non-grounding position of the heat dissipation plate 10, avoiding excitation of a new magnetic field at the non-grounding position of the heat dissipation plate 10, so that the performance of the antenna 60 is not affected.

It may be understood that the adhesive 32 and the adhesive layer 33 can fasten the fourth connection region 112 of the heat dissipation plate 10 to the second connection region 22 of the support plate 20, and can also electrically connect the fourth connection region 112 of the heat dissipation plate 10 to the second connection region 22 of the support plate 20. The adhesive 32 and the adhesive layer 33 have effect of "one thing for a plurality of purposes".

It may be understood that, a manner of fastening the fourth connection region 112 of the heat dissipation plate 10 to the second connection region 22 of the support plate 20 may include a manner of fastening the fourth connection region 112 of the heat dissipation plate 10 to the first plate region 221 of the second connection region 22 of the support plate 20, a manner of fastening the fourth connection region 112 of the heat dissipation plate 10 to the second plate region 222 of the second connection region 22 of the support plate 20, a manner of fastening the fourth connection region 112 of the heat dissipation plate 10 to the first edge region 223 of the second connection region 22 of the support plate 20, and a manner of fastening the fourth connection region 112 of the heat dissipation plate 10 to the second edge region 224 of the second connection region 22 of the support plate 20. The following uses a manner of fastening the heat dissipation plate 10 to the first plate region 221 of the support plate 20 and a manner of fastening the heat dissipation plate 10 to the first edge region 223 of the support plate 20 as examples for description.

As shown in FIG. 15, in some embodiments, when the fourth connection region 112 of the first cover 11 of the heat dissipation plate 10 is fastened to the first plate region 221 of the second connection region 22 of the support plate 20 through cooperation between the first adhesive 321 and the first adhesive layer 331, materials of the first adhesive 321 and the first adhesive layer 331 may include an insulating material, so that the fourth connection region 112 of the first cover 11 is insulated from the first plate region 221 of the second connection region 22 of the support plate 20.

In some implementations, when the fourth connection region 112 of the first cover 11 of the heat dissipation plate 10 is fastened to the first plate region 221 of the second connection region 22 of the support plate 20 by only using the first adhesive 321 or the first adhesive layer 331, the material of the first adhesive 321 may include an insulating material or the material of the first adhesive layer 331 may include an insulating material, so that the fourth connection region 112 of the first cover 11 is insulated from the first plate region 221 of the second connection region 22 of the support plate 20.

As shown in FIG. 16, in some embodiments, when the fourth connection region 112 of the first cover 11 of the heat dissipation plate 10 is fastened to the first edge region 223 of the support plate 20 by using the second adhesive layer 332, a material of the second adhesive layer 332 may include an insulating material, so that the fourth connection region 112 of the first cover 11 is insulated from the first edge region 223 of the support plate 20.

As shown in FIG. 17, when the fourth connection region 112 of the first cover 11 of the heat dissipation plate 10 is fastened to the first edge region 223 of the support plate 20 by using the second adhesive 322, a material of the second adhesive 322 may include an insulating material, so that the fourth connection region 112 of the first cover 11 is insulated from the first edge region 223 of the support plate 20.

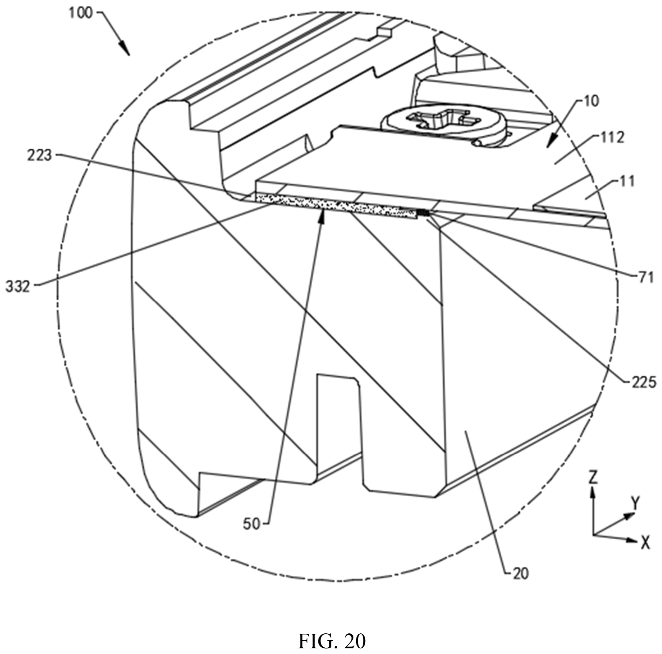

FIG. 20 is a partial cross-sectional view of the middle frame 100 shown in FIG. 2 and cut along F-F in some other embodiments.

As shown in FIG. 20, the middle frame 100 may further include a barrier wall insulation member 71. The barrier wall insulation member 71 may be connected between the fourth connection region 112 of the first cover 11 of the heat dissipation plate 10 and the first barrier wall 225 of the support plate 20. In this way, the fourth connection region 112 of the first cover 11 of the heat dissipation plate 10 can be insulated from the first barrier wall 225 of the support plate 20 through the barrier wall insulation member 71.

For example, the barrier wall insulation member 71 may be Mylar (mylar). The barrier wall insulation member 71 may be bonded between the fourth connection region 112 of the first cover 11 and the first barrier wall 225 of the support plate 20.

For example, the barrier wall insulation member 71 may be insulating paint. The insulating paint may be disposed in the fourth connection region 112 of the first cover 11, or disposed on the first barrier wall 225. In this case, the insulating paint enables the fourth connection region 112 of the first cover 11 to be insulated from the first barrier wall 225 of the support plate 20.

It may be understood that, with reference to the related accompanying drawings, the foregoing specifically describes the solution in which the third connection region 111 of the heat dissipation plate 10 is electrically connected to the first connection region 21 of the support plate 20 through the fastener 31, and the fourth connection region 112 of the heat dissipation plate 10 is insulated from the second connection region 22 of the support plate 20 through the adhesive 32 and the adhesive layer 33. With reference to related accompanying drawings, the following specifically describes several manners of electrically connecting the third connection region 111 of the heat dissipation plate 10 to the first connection region 21 of the support plate 20.

As shown in FIG. 18, in some embodiments, the thickness H of the first cover 11 of the heat dissipation plate 10 may be less than or equal to 0.2 mm. For example, the thickness H of the first cover 11 may be 0.2 mm (millimeter), 0.15 mm (millimeter), 0.14 mm (millimeter), 0.13 mm (millimeter), 0.12 mm (millimeter), or 0.1 mm (millimeter). In some implementations, the thickness L of the first cover 11 may not be specifically limited.

In some embodiments, the third connection region 111 of the first cover 11 of the heat dissipation plate 10 may be fastened to the first connection region 21 of the support plate 20 by using a welding process. In this case, the welding joint 52 is formed between the third connection region 111 of the first cover 11 and the first connection region 21 of the support plate 20. The welding joint 52 may be a conductive member 50. In this case, the third connection region 111 of the heat dissipation plate 10 may be electrically connected to the first connection region 21 of the support plate 20 through the welding joint 52. Because the first connection region 21 of the support plate 20 is the grounding position for the antenna 60, the third connection region 111 of the heat dissipation plate 10 can be grounded through the welding joint 52. In this way, the heat dissipation plate 10 is not likely to generate clutter to the surrounding antenna 60, and therefore the performance of the antenna 60 is not affected.

It may be understood that, in comparison with the solution in which the heat dissipation plate 10 is grounded through the fastener 31, in this implementation of this application, the heat dissipation plate 10 is grounded through the welding joint 52, so that electrical connection between the heat dissipation plate 10 and the support plate 20 is more secure and reliable, and the structures of the third connection region 111 of the heat dissipation plate 10 and the first connection region 21 of the support plate 20 are not prone to damage caused by providing an opening, to ensure that the heat dissipation plate 10 and the support plate 20 have good structure strength.

As shown in FIG. 19, in some embodiments, the middle frame 100 may include the third adhesive 323. A material of the third adhesive 323 includes a conductive material. For example, the third adhesive 323 may be conductive foam or a conductive adhesive. Reference numerals of the conductive foam and the conductive adhesive may be the same as the reference numeral of the third adhesive 323. In this case, the third adhesive 323 is a conductive member 50.

It may be understood that, the third connection region 111 of the heat dissipation plate 10 is fastened to the first connection region 21 of the support plate 20 by using the third adhesive 323, the material of the third adhesive 323 includes the conductive material, and the first connection region 21 of the support plate 20 is the grounding position for the antenna 60, so that the third connection region 111 of the heat dissipation plate 10 can be electrically connected to the first connection region 21 of the support plate 20 through the third adhesive 323. In other words, the third connection region 111 of the heat dissipation plate 10 can be grounded through the third adhesive 323. In this way, the heat dissipation plate 10 is not likely to generate clutter to the surrounding antenna 60, and therefore the performance of the antenna 60 is not affected.

It may be understood that, in comparison with the solution in which the heat dissipation plate 10 is grounded through the fastener 31, in this implementation of this application, the heat dissipation plate 10 can be grounded through the third adhesive 323, so that the structures of the third connection region 111 of the heat dissipation plate 10 and the first connection region 21 of the support plate 20 are not prone to damage caused by providing an opening, to ensure that the heat dissipation plate 10 and the support plate 20 have good structure strength. In addition, the grounding manner in this implementation of this application is simple, and material costs are low.

With reference to the related accompanying drawings, the foregoing specifically describes the manner of fastening the heat dissipation plate 10 to the middle plate 102, the manner of grounding the heat dissipation plate 10 and the middle plate 102, and setting of insulation between the heat dissipation plate 10 and the antenna 60 of the middle plate 102. With reference to related accompanying drawings, the following specifically describes a manner of positioning the heat dissipation plate 10 and the middle plate 102, to ensure that the heat dissipation plate 10 is accurately connected to the middle plate 102.

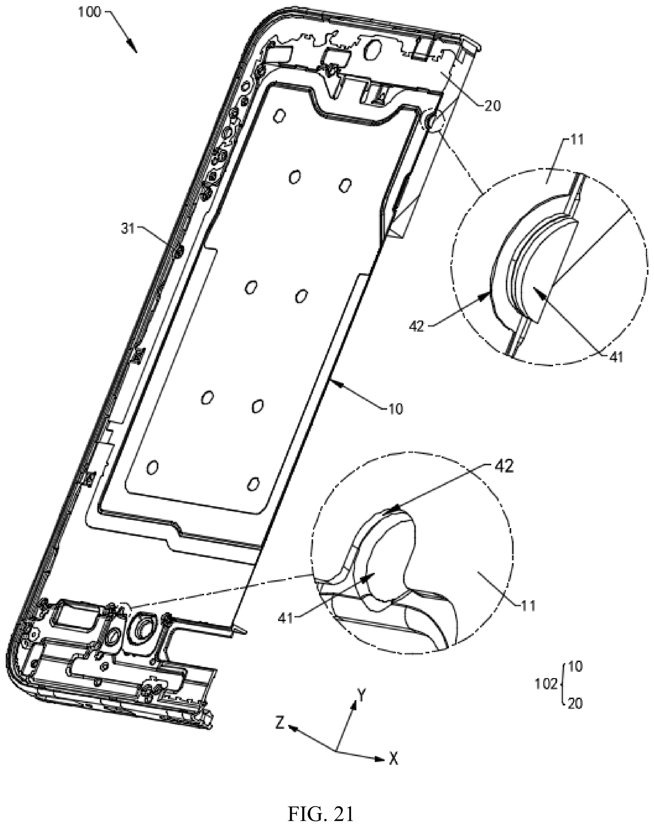

FIG. 21 is a partial cross-sectional view of the middle frame 100 shown in FIG. 2 and cut along G-G in some embodiments.

As shown in FIG. 21, in some embodiments, the support plate 20 may be provided with a plurality of first positioning holes 41. There may be two first positioning holes 41. The first positioning hole 41 may be circular. It may be understood that a quantity, shapes, and positions of first positioning holes 41 are not specifically limited in this application, and may be flexibly set according to a requirement.

In some embodiments, the first cover 11 of the heat dissipation plate 10 may be provided with a plurality of second positioning holes 42. It may be understood that a quantity, shapes, and positions of second positioning holes 42 may match the quantity, shapes, and positions of first positioning holes 41.

In some embodiments, the second positioning hole 42 may be provided opposite to the first positioning hole 41. It may be understood that, when there are a plurality of second positioning holes 42 and a plurality of first positioning holes 41, the plurality of second positioning holes 42 may be provided opposite to the plurality of first positioning holes 41 in a one-to-one correspondence.

It may be understood that, because the first cover 11 of the heat dissipation plate 10 may be fastened to the support plate 20 by using a plurality of fasteners 31, in a procedure of assembling the heat dissipation plate 10 and the support plate 20, a plurality of fastening holes of the heat dissipation plate 10 need to be accurately aligned with a plurality of fastening holes of the support plate 20. In this implementation of this application, the first positioning holes 41 may be provided on the support plate 20, and the second positioning holes 42 may be provided on the heat dissipation plate 10. In this case, in a procedure of assembling the heat dissipation plate 10 and the support plate 20, the first positioning holes 41 are first aligned with the second positioning holes 42, and then positioning rods of an assembly tool are inserted into the first positioning holes 41 and the second positioning holes 42, to fix a relative position of the heat dissipation plate 10 on the support plate 20. In this case, the plurality of fastening holes of the heat dissipation plate 10 may also be accurately aligned with the plurality of fastening holes of the middle plate 102. In this way, a process for locking the fastener 31 into the fastening hole of the heat dissipation plate 10 and the fastening hole of the support plate 20 is simple. In addition, the fastener 31 is not prone to a problem such as floating, loose locking, or assembly misalignment.

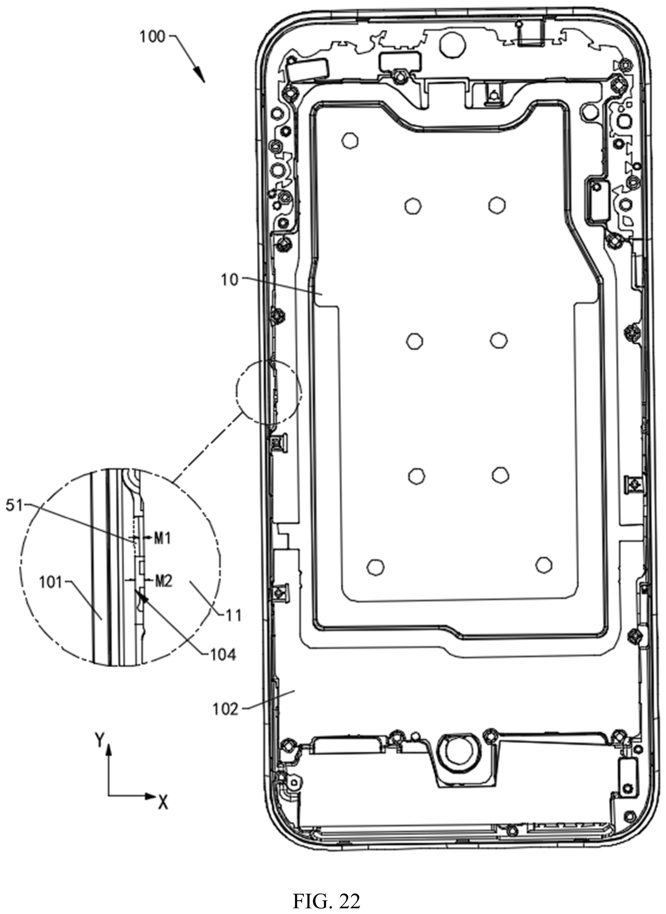

FIG. 22 is a diagram of a structure of the middle frame 100 shown in FIG. 2 at another angle in an implementation.

As shown in FIG. 22, in some embodiments, a limiting boss 51 may protrude from the inner side surface 104 of the side frame 101. In FIG. 22, a dashed line is used to schematically distinguish between the side frame 101 and the limiting boss 51.

The first cover 11 of the heat dissipation plate 10 may be spaced from (that is, not in contact with) the limiting boss 51. In this case, the first cover 11 of the heat dissipation plate 10 may be insulated from the side frame 101, to avoid a problem of radiated spurious emission (radiated spurious emission, RSE) of the antenna 60.

In some embodiments, a distance M1 between the first cover 11 of the heat dissipation plate 10 and the limiting boss 51 may be less than a distance M2 between the first cover 11 of the heat dissipation plate 10 and the inner side surface 104 of the side frame 101. In this way, because the distance between the first cover 11 of the heat dissipation plate 10 and the limiting boss 51 is smaller, positioning of the heat dissipation plate 10 and the side frame 101 can be implemented to some extent through cooperation between the first cover 11 of the heat dissipation plate 10 and the limiting boss 51. In this case, the plurality of fastening holes of the heat dissipation plate 10 may also be accurately aligned with the plurality of fastening holes of the support plate 20. A process for locking the fastener 31 into the fastening hole of the heat dissipation plate 10 and the fastening hole of the support plate 20 is simple. In addition, the fastener 31 is not prone to a problem such as floating, loose locking, or assembly misalignment.

It may be understood that embodiments of this application and features in embodiments may be combined with each other if there is no conflict, and any combination of features in different embodiments also falls within the protection scope of this application. In other words, the plurality of embodiments described above may be further combined according to an actual requirement.

It may be understood that all the foregoing accompanying drawings are example illustrations of this application, and do not represent actual sizes of products. In addition, a size proportion relationship between components in the accompanying drawings is not intended to limit an actual product in this application. The foregoing descriptions are merely some embodiments and implementations of this application, but are not intended to limit the protection scope of this application. Any variation or replacement readily figured out by a person skilled in the art within the technical scope disclosed in this application shall fall within the protection scope of this application. Therefore, the protection scope of this application should be subject to the protection scope of the claims.

## Claims

1. A heat dissipation plate (10), comprising a first cover (11), a second cover (12), a capillary structure (13), and a cooling medium (14), wherein
the second cover (12) comprises a middle region (121) and an edge region (122) disposed around the middle region (121), and the middle region (121) comprises a shaping region (1211) and an accommodation region (1212) connected to the shaping region (1211);
the edge region (122) is fastened to the first cover (11), and the accommodation region (1212) of the middle region (121) and the first cover (11) are spaced from each other and enclose an accommodation cavity (15);
the capillary structure (13) is fastened to the first cover (11) and located in the accommodation cavity (15), and the cooling medium (14) is disposed in the accommodation cavity (15); and
the shaping region (1211) of the middle region (121) is fastened to the first cover (11).

2. The heat dissipation plate (10) according to claim 1, wherein the shaping region (1211) is concave toward the first cover (11) and fastened to the first cover (11).

3. The heat dissipation plate (10) according to claim 1, wherein the accommodation region (1212) is disposed around the shaping region (1211).

4. The heat dissipation plate (10) according to any one of claims 1 to 3, wherein there are a plurality of shaping regions (1211), and the plurality of shaping regions (1211) are spaced from each other in a length direction of the heat dissipation plate (10).

5. The heat dissipation plate (10) according to claim 4, wherein the edge region (122) of the second cover (12) comprises a first edge (1221) and a second edge (1222) that are arranged in the length direction of the heat dissipation plate (10), and a shortest distance between the first edge (1221) and the second edge (1222) is a; and
there are two shaping regions (1211), and a distance between a center of a 1^{st} shaping region (1211) and a center of a 2^{nd} shaping region (1211) is b, wherein a and b satisfy 0.25a≤b≤0.4a.

6. The heat dissipation plate (10) according to claim 5, wherein the edge region (122) of the second cover (12) comprises a third edge (1223) and a fourth edge (1224) that are arranged in a width direction of the heat dissipation plate (10), the third edge (1223) and the fourth edge (1224) are connected between the first edge (1221) and the second edge (1222), and a shortest distance between the third edge (1223) and the fourth edge (1224) is c; and
a distance between the center of the 1^{st} shaping region (1211) and the third edge (1223) is d, wherein c and d satisfy 0.4c≤d≤0.6c.

7. The heat dissipation plate (10) according to any one of claims 1 to 6, wherein a part of the accommodation region (1212) is concave toward the first cover (11) and fastened to the capillary structure (13).

8. A middle frame (100), comprising a side frame (101) and a middle plate (102), wherein the middle plate (102) is fastened to an inner side surface (104) of the side frame (101), and the middle plate (102) comprises a support plate (20) and the heat dissipation plate (10) according to any one of claims 1 to 7; and
the support plate (20) is provided with a hollow region (20a), the first cover (11) is fastened to the support plate (20), and the first cover (11) covers the hollow region (20a) and encloses a battery compartment (103).

9. The middle frame (100) according to claim 8, wherein there are two shaping regions (1211), a 1^{st} shaping region (1211) is directly opposite to a boundary between the battery compartment (103) and the support plate (20), and a 2^{nd} shaping region (1211) is directly opposite to the battery compartment (103).

10. The middle frame (100) according to claim 8 or 9, wherein the support plate (20) comprises a first connection region (21) and a second connection region (22), the second connection region (22) is fastened to the first connection region (21), the first cover (11) comprises a third connection region (111) and a fourth connection region (112), and the fourth connection region (112) is fastened to the third connection region (111); and
the third connection region (111) of the heat dissipation plate (10) is fastened to the first connection region (21) of the support plate (20) by using a fastener (31), and the fourth connection region (112) of the heat dissipation plate (10) is fastened to the second connection region (22) of the support plate (20) by using an adhesive (32) and/or an adhesive layer (33).

11. The middle frame (100) according to claim 10, wherein the first connection region (21) of the support plate (20) is provided with a first groove (212), a fastening hole (211) of the support plate (20) is located in the first groove (212), at least a part of the third connection region (111) of the first cover (11) is concave toward a bottom wall of the first groove (212) to form a second groove (114), and a fastening hole (113) of the first cover (11) is located in the second groove (114); and
a part of the fastener (31) is located in the second groove (114).

12. The middle frame (100) according to claim 10 or 11, wherein the third connection region (111) comprises a plurality of protrusions (115) that are spaced from each other, the plurality of protrusions (115) are disposed around the fastening hole (113) of the first cover (11), and the plurality of protrusions (115) abut against the first connection region (21).

13. The middle frame (100) according to claim 12, wherein the second connection region (22) comprises a first plate region (221), the adhesive (32) comprises a first adhesive (321), and the adhesive layer (33) comprises a first adhesive layer (331); and
the fourth connection region (112) of the first cover (11) is fastened to the first plate region (221) of the support plate (20) of the support plate (20) through cooperation between the first adhesive (321) and the first adhesive layer (331).

14. The middle frame (100) according to claim 13, wherein the first adhesive (321) is provided with a dispensing hole (3211), and the first adhesive layer (331) is disposed in the dispensing hole (3211).

15. The middle frame (100) according to claim 13 or 14, wherein the second connection region (22) comprises a first edge region (223), and the first edge region (223) is fastened to the first plate region (221); and
the adhesive layer (33) comprises a second adhesive layer (332), and the fourth connection region (112) of the first cover (11) is fastened to the first edge region (223) of the support plate (20) by using the second adhesive layer (332).

16. The middle frame (100) according to claim 15, wherein a first barrier wall (225) protrudes from the first edge region (223) of the support plate (20), and the first barrier wall (225) is located between the second adhesive layer (332) and the battery compartment (103); and
the middle frame 100 further comprises a barrier wall insulation member (71), and the barrier wall insulation member (71) is connected between the fourth connection region (112) of the first cover (11) and the first barrier wall (225).

17. The middle frame (100) according to claim 13 or 14, wherein the second connection region (22) comprises a first edge region (223), the first edge region (223) is fastened to the first plate region (221), and in a width direction of the middle frame (100), a width D of the first edge region (223) is greater than or equal to 1.5 millimeters; and
the adhesive (32) comprises a second adhesive (322), and the fourth connection region (112) of the first cover (11) is fastened to the first edge region (223) of the support plate (20) by using the second adhesive (322).

18. The middle frame (100) according to claim 8 or 9, wherein the support plate (20) comprises a first connection region (21) and a second connection region (22), the second connection region (22) is fastened to the first connection region (21), the first cover (11) comprises a third connection region (111) and a fourth connection region (112), the fourth connection region (112) is fastened to the third connection region (111), and a thickness H of the first cover (11) is less than or equal to 0.2 mm; and
the third connection region (111) of the heat dissipation plate (10) is fastened to the first connection region (21) of the support plate (20) by using a welding joint (52), and the fourth connection region (112) of the heat dissipation plate (10) is fastened to the second connection region (22) of the support plate (20) by using an adhesive (32) and/or an adhesive layer (33).

19. The middle frame (100) according to any one of claims 8 to 18, wherein a part of the side frame (101) forms a radiator (61) of an antenna (60), or a radiator (61) of an antenna (60) is fastened to the inner side surface (104) of the side frame (101);
the support plate (20) comprises the first connection region (21) and the second connection region (22), the second connection region (22) is fastened to the first connection region (21), and the first connection region (21) is a grounding position for the radiator (61) of the antenna (60);
the first cover (11) comprises the third connection region (111) and the fourth connection region (112), and the fourth connection region (112) is fastened to the third connection region (111); and
the third connection region (111) of the heat dissipation plate (10) is electrically connected to the first connection region (21) of the support plate (20) through a conductive member (50), and the fourth connection region (112) of the heat dissipation plate (10) is insulated from the second connection region (22) of the support plate (20) through an insulation member (70).

20. The middle frame (100) according to claim 19, wherein the conductive member (50) comprises the fastener (31), the welding joint (52), or conductive foam (323), a material of the fastener (31) comprises a conductive material, the insulation member (70) comprises the adhesive (32) or the adhesive layer (33), and materials of the adhesive (32) and the adhesive layer (33) comprise an insulating material.

21. The middle frame (100) according to claim 19 or 20, wherein a limiting boss (51) protrudes from the inner side surface (104) of the side frame (101), and a distance between the heat dissipation plate (10) and the limiting boss (51) is less than a distance between the heat dissipation plate (10) and the inner side surface (104) of the side frame (101).

22. The middle frame (100) according to any one of claims 8 to 21, wherein the support plate (20) is provided with a plurality of first positioning holes (41), the first cover (11) is provided with a plurality of second positioning holes (42), and the plurality of second positioning holes (42) are provided opposite to the plurality of first positioning holes (41) in a one-to-one correspondence.

23. An electronic device (1000), comprising a rear cover (200), a display (300), a battery (500), and the middle frame (100) according to any one of claims 8 to 22, wherein
at least a part of the display (300) is fastened to the second cover (12) of the heat dissipation plate (10), the battery (500) is fastened to the first cover (11) of the heat dissipation plate (10), and the battery (500) is located in the battery compartment (103); and
the rear cover (200) is fastened to the side frame (101) of the middle frame (100), the rear cover (200) is located on a side that is of the middle plate (102) of the middle frame (100) and that is away from the display (300), and the rear cover (200) covers the battery (500).

24. The electronic device (1000) according to claim 23, wherein the electronic device (1000) further comprises a display insulation member (80), and the display insulation member (80) is located between the display and the second cover (12).

25. The electronic device (1000) according to claim 23 or 24, wherein the electronic device (1000) further comprises a circuit board (400), and the circuit board (400) is fastened to the support plate (20) and located on a side that is of the support plate (20) and that is away from the first cover (11).
